# FASCICULE DE BREVET EUROPEEN

(11) **EP 1 988 550 B1**
(45) Date de publication et mention de la délivrance du brevet: **25.08.2010**
(21) Numéro de dépôt: 08007687.0
(22) Date de dépôt: 21.04.2008
(51) Int. Cl.: G11C 16/22

(54) **Mémoire non volatile à secteurs auxiliaires tournants**
Nicht flüchtiger Speicher mit drehbaren Hilfssegmenten
Non-volatile memory with rotating auxiliary sectors

(30) Priorité: 02.05.2007 FR 0703152; 02.05.2007 FR 0703153; 02.05.2007 FR 0703154
(43) Date de publication de la demande: 05.11.2008
(73) Titulaire: STMICROELECTRONICS SA, 92120 Montrouge (FR); STMicroelectronics Srl, 20041 Agrate Brianza (MB) (IT)
(72) Inventeur: La Rosa, Francesco, 13790 Rousset (FR); Conte, Antonino, 95030 Tremestieri Etneo (IT)
(74) Mandataire: Marchand, André

(56) Documents cités:
- US-A1- 2004 114 431
- US-B1- 6 571 312
- US-B2- 6 941 413

## Description

La présente invention concerne les mémoires non volatiles et notamment les mémoires effaçables et programmables électriquement de type FLASH.

Le marché des mémoires effaçables et programmables électriquement sur microplaquettes de silicium est traditionnellement partagé entre la famille des mémoires EEPROM et celle des mémoires FLASH (ou FLASH-EEPROM).

Les mémoires EEPROM comprennent des cellules mémoire comportant un transistor à grille flottante et un transistor d'accès. Des transistors de contrôle de grille permettent d'appliquer sélectivement une tension d'effacement à des groupes de cellules mémoire ou mots comprenant un faible nombre de cellules mémoire, par exemple de 8 à 16 cellules mémoire. Elles offrent ainsi une très fine granularité en effacement. Par ailleurs les transistors d'accès isolent les transistors à grille flottante des lignes de bit et permettent de prévoir des tensions de seuil de signes différents entre des cellules mémoire effacées et des cellules mémoire programmées. Ces mémoires sont donc faciles à mettre en oeuvre mais les cellules mémoire occupent une surface importante en raison de leur structure à deux transistors.

Les mémoires de type FLASH ne comportent qu'un transistor à grille flottante par cellule mémoire et présentent ainsi l'avantage d'une grande compacité en termes de surface de silicium occupée (nombre de cellules mémoire par unité de surface). En contrepartie, l'absence de transistor d'accès nécessite de prévoir des tensions de seuil positives tant pour les cellules mémoire effacées que les cellules mémoire programmées, afin de ne pas créer des courts-circuits sur les lignes de bit. Les oxydes de grille doivent ainsi être épais pour maintenir durablement les charges électriques piégées dans les grilles flottantes, ce qui entraîne une augmentation notable du temps d'effacement. Plus particulièrement, l'effacement des cellules mémoire FLASH est généralement effectué par effet tunnel tandis que leur écriture (programmation) est effectuée par injection d'électrons chauds. Le temps nécessaire à l'écriture des cellules mémoire est court, par exemple 5 microsecondes, tandis que le temps d'effacement est long, par exemple 100 millisecondes. Par ailleurs, la programmation par injection d'électrons chauds entraîne l'apparition d'un fort courant de programmation, de sorte que le nombre de cellules mémoire pouvant être écrites simultanément doit être limité. Ainsi, l'écriture de cellules mémoire est généralement effectuée mot par mot, contrairement aux mémoires EEPROM qui permettent d'écrire simultanément toute une page. Enfin, les mémoires FLASH ne sont effaçables que par secteur, un secteur comprenant des transistors dont les bornes de potentiel bas (bornes de source pour des transistors de type NMOS) sont reliées au même substrat.

Les mémoires FLASH ont ainsi été, originellement, dédiées au stockage de masse. Divers perfectionnements furent ensuite proposés afin qu'elles puissent offrir des caractéristiques se rapprochant des mémoires EEPROM, et ce afin d'ouvrir aux mémoires FLASH des domaines d'application originellement réservés aux mémoires EEPROM. De façon générale, le but poursuivi par ces perfectionnements est d'offrir des mémoires FLASH capables de rivaliser avec les mémoires EEPROM en termes de souplesse d'emploi, sans perdre leurs avantages en termes de capacité de stockage par unité de surface de silicium.

Parmi les perfectionnements ayant permis de faire évoluer le marché des mémoires FLASH, on peut citer :
- la conception d'une mémoire FLASH programmable par page, telle que décrite par le brevet EP 1 111 621 au nom de la demanderesse. Une telle mémoire comporte un tampon de page volatile lui permettant de recevoir des données représentant une page entière. Un algorithme interne (exécuté par un séquenceur à logique câblée ou un microprocesseur) assure l'écriture de la page mot par mot mais de façon transparente pour l'utilisateur, qui se voit ainsi offrir la possibilité d'écrire un secteur entier page par page au lieu de l'écrire mot par mot ;
- la conception d'une mémoire FLASH effaçable par page, telle que décrite par le brevet EP 1 342 244 au nom de la demanderesse. Dans une telle mémoire, des tensions d'inhibition sont appliquées aux cellules mémoire ne devant pas être effacées au sein d'un secteur en cours d'effacement. On obtient une granularité en effacement qui n'est pas aussi fine que celle d'une mémoire EEPROM mais qui s'en rapproche (bien que certaines mémoires EEPROM soient également prévues effaçables par page et non par mot). Grâce aux tensions d'inhibition, l'étape d'effacement peut être contrôlée de manière à effacer simultanément une ou plusieurs pages au sein d'un même secteur, sans affecter les autres pages du même secteur ;
- la conception d'une mémoire FLASH programmable par mot et effaçable par page, ou page-FLASH, telle que décrite par le brevet EP 1 486 986 au nom de la demanderesse. Une telle mémoire comporte également un tampon de page mais le procédé d'effacement par page selon EP 1 342 244 y est combiné avec un algorithme interne simulant une écriture par mot. L'algorithme interne se charge de récupérer les mots présents dans une page cible et de les enregistrer dans le tampon de page conjointement au(x) nouveau (x) mot(s) fourni(s) par l'utilisateur, pour obtenir une page mise à jour. La page cible est effacée et la page mise à jour y est écrite, de sorte que la page cible comprend ensuite le ou les nouveaux mots et des mots qui étaient présents dans la page initiale. L'utilisateur peut ainsi appliquer une commande d'écriture d'un mot sans se soucier d'effacer préalablement la page, cela étant pris en charge par l'algorithme.

Ce dernier perfectionnement a permis de commercialiser des mémoires FLASH offrant les mêmes fonctionnalités apparentes que des mémoires EEPROM, mais dans lesquelles des limitations subsistent, à savoir :
- le temps d'effacement long, qui peut s'avérer gênant dans certaines applications. En effet le temps apparent d'écriture d'un mot est essentiellement imposé par le temps d'effacement de la page, puisque l'algorithme interne doit effacer la page entière chaque fois qu'un nouveau mot est écrit ;
- une absence de protection contre les coupures intempestives de tension d'alimentation. En effet, si une coupure d'alimentation survient pendant l'effacement de la page cible et tandis que la page mise à jour se trouve encore dans le tampon de page volatile, toutes les données de la page sont irrémédiablement perdues. De ce fait les mémoires FLASH ne peuvent actuellement être utilisées comme mémoires enchâssées ("embedded memories") dans des circuits intégrés destinés à des applications où le risque de coupure d'alimentation électrique est élevé. Il s'agit typiquement des applications aux cartes à puce ou aux étiquettes électroniques, dans lesquelles l'alimentation des circuits intégrés est fournie par un dispositif externe (lecteur) et peut disparaître à tout instant en cas "d'arrachement" (retrait de la carte de la fente du lecteur pour une carte à contact, éloignement brutal de la carte de la bobine du lecteur pour une carte sans contact à couplage inductif, etc.).

Il peut ainsi être souhaité de perfectionner les mémoires de type FLASH et de façon générale tout type de mémoire non volatile présentant tout ou partie des propriétés précitées, selon au moins l'un des axes de perfectionnement suivants :
- optimiser le temps d'effacement apparent des données ;
- optimiser le temps d'effacement apparent des données sans devoir interrompre un flot d'instructions ;
- protéger des données contre le risque de coupure d'alimentation électrique pendant le processus d'écriture.

Chacun de ces axes de perfectionnement est visé indépendamment des autres, ou en combinaison avec les autres, selon les applications concernées.

Concernant la protection des données contre les coupures d'alimentation, la demande de brevet US2005/0251643 décrit un procédé d'écriture protégé contre l'arrachement ("tearing proof programming", paragraphe 0008) adapté aux mémoires FLASH. Les pages de la mémoire sont utilisées pour mémoriser, en sus des données utiles, une adresse logique de page et une valeur de comptage. Une table de correspondance permet d'associer une adresse logique à une adresse physique (adresse électrique). Lorsqu'une donnée doit être écrite dans une page, le contenu de la page est copié dans un tampon de page. La nouvelle donnée y est incorporée, tandis que la valeur de comptage est incrémentée. Le contenu de la page mis à jour est ensuite écrit dans une autre page, avec la même adresse logique. La page initiale est ensuite effacée. En résumé, les pages sont indexées dans des pages physiques d'adresse quelconque et ne sont identifiables qu'à partir de leur adresse logique. Le fait d'effacer la page initiale après avoir sauvegardé la mise à jour dans une autre page physique permet de pallier le risque de perdre les données en cas de coupure d'alimentation électrique pendant ou après l'effacement de la page initiale. En cas de doute sur l'identité de la page valide lors de la remise sous tension, lorsque deux pages de même adresse logique se trouvent dans la mémoire, la page la plus récente est celle qui contient la plus grande valeur de comptage.

Ce procédé nécessite de gérer une valeur de comptage qui doit nécessairement repasser par zéro, la taille du champ de comptage n'étant pas infinie, de sorte qu'une valeur de comptage récente après remise à zéro peut présenter une valeur inférieure à une valeur de comptage précédente générée avant la remise à zéro. Par ailleurs, si une coupure de tension intervient pendant que la page initiale est en cours d'effacement, les cellules mémoire de la page ne sont pas entièrement effacées. Les données qu'elles contiennent peuvent alors présenter des valeurs erronées, du fait que les charges électriques dans les cellules mémoire sont indéterminées tant que le processus d'effacement n'est pas achevé. Ainsi, après remise sous tension suite à une coupure d'alimentation, une valeur de comptage lue dans des cellules mémoire incomplètement effacées pourrait présenter une valeur arbitraire supérieure à la valeur de comptage présente dans la page dernièrement mise à jour. Dans ces conditions, la page ancienne mal effacée contenant des données invalides pourrait être vue comme la "bonne" page, tandis que la vraie "bonne" page serait effacée.

Concernant la diminution du temps d'effacement apparent, il apparaît que le procédé d'écriture décrit par US2005/0251643 repose sur une étape élémentaire consistant à écrire de nouvelles données sans avoir effacé les données précédentes. On peut observer que cette étape élémentaire permet de réduire le temps d'effacement apparent d'une page puisque l'écriture des données de page mises à jour est effectuée sans effacement préalable de la page initiale. Toutefois, il n'est pas envisageable d'écrire continuellement des données dans des pages effacées, à moins de disposer d'un espace mémoire infini. Il faudrait donc interrompre, à un instant donné, le processus d'écriture, pour effacer des pages invalidées et libérer de l'espace mémoire. Or, une telle interruption peut ne pas être souhaitable ou envisageable dans certaines applications, notamment celles qui nécessitent de gérer un flot ininterrompu d'instructions d'écriture.

Une telle étape élémentaire est également enseignée par le brevet US 6,212,105, mais est mise en oeuvre différemment : lorsqu'une nouvelle donnée doit être écrite, la nouvelle donnée est écrite temporairement dans un emplacement auxiliaire et l'emplacement cible est effacé ; puis la donnée est écrite dans l'emplacement cible effacé et l'emplacement auxiliaire est effacé. Ce procédé nécessite deux étapes d'effacement consécutives pour qu'une donnée soit mémorisée dans un emplacement cible, et n'est pas adapté aux mémoires présentant un temps d'effacement supérieur au temps d'écriture.

Par ailleurs, le brevet US 2004/0114431 décrit un procédé d'écriture de données dans une mémoire non volatile comportant des cellules mémoire devant être effacées avant d'être écrites, comprenant les étapes consistant à prévoir une zone mémoire principale non volatile comprenant des pages cibles, prévoir une zone mémoire auxiliaire non volatile comprenant des pages effacées utilisables pour écrire des données, des pages auxiliaires contenant des données rattachées à des pages cible à effacer ou en cours d'effacement, des pages auxiliaires contenant des données à transférer dans des pages cible effacées, et des pages auxiliaires à effacer ou en cours d'effacement.

Selon un mode de réalisation de l'invention, il est prévu un procédé d'écriture de données dans une mémoire non volatile comportant des cellules mémoire devant être effacées avant d'être écrites comme indiqué dans la revendication 1. Le procédé comprend les étapes consistant à prévoir, dans la mémoire, une zone mémoire principale non volatile comprenant des pages cible, une zone mémoire auxiliaire non volatile comprenant des pages auxiliaires, et, dans la zone mémoire auxiliaire : un secteur courant comprenant des pages auxiliaires effacées utilisables pour écrire des données, un secteur de sauvegarde comprenant des pages auxiliaires contenant des données rattachées à des pages cible à effacer ou en cours d'effacement, un secteur de transfert comprenant des pages auxiliaires contenant des données à transférer dans des pages cible effacées, et un secteur indisponible comprenant des pages auxiliaires à effacer ou en cours d'effacement.

Selon un mode de réalisation, le procédé comprend, en réponse à une commande d'écriture d'une donnée dans une page cible, les étapes consistant à appliquer une étape d'effacement partiel aux pages auxiliaires du secteur indisponible et à des pages cible rattachées à des pages du secteur de sauvegarde, transférer des données d'une page auxiliaire du secteur de transfert vers une page effacée de la zone mémoire principale, si la page auxiliaire est valide, et invalider la page auxiliaire, et écrire la donnée dans une page auxiliaire effacée du secteur courant, et invalider la page cible.

Selon un mode de réalisation, le procédé comprend, en réponse à une commande d'écriture d'une donnée dans une page cible, les étapes consistant à écrire la donnée dans une seconde page auxiliaire effacée, si une donnée précédente de même adresse de page cible a déjà été écrite dans une première page auxiliaire, et invalider la première page auxiliaire.

Selon un mode de réalisation, le procédé comprend les étapes consistant à prévoir un champ d'adresse dans les pages auxiliaire, et lorsqu'une donnée est écrite dans une page auxiliaire, écrire dans le champ d'adresse de la page auxiliaire l'adresse de page cible de la donnée.

Selon un mode de réalisation, le procédé comprend, en réponse à une commande d'écriture d'une donnée dans une page cible, l'étape consistant à écrire directement la donnée dans la page cible ou dans une page auxiliaire valide contenant une donnée précédemment écrite ayant la même adresse de page cible, si des cellules mémoire devant recevoir la donnée sont effacées dans la page cible ou dans la page auxiliaire.

Selon un mode de réalisation, le procédé comprend les étapes consistant à : avant d'écrire une donnée dans une page auxiliaire, lire un ensemble initial de données dans une page source, insérer la donnée à écrire dans l'ensemble initial de données, pour obtenir un ensemble de données mis à jour, puis écrire l'ensemble de données mis à jour dans la page auxiliaire.

Selon un mode de réalisation, le procédé comprend les étapes consistant à tenir à jour une table de correspondance entre des adresses de pages cible invalides et des adresses de pages auxiliaires valides, et lorsqu'une donnée doit être lue dans une page cible, lire la donnée dans une page auxiliaire valide si l'adresse de la page auxiliaire valide existe dans la table de correspondance, sinon lire la donnée dans la page cible.

Selon un mode de réalisation, le procédé comprend une étape consistant à utiliser un pointeur de page auxiliaire pour désigner à la fois dans le secteur de transfert une page auxiliaire dont le contenu doit être transféré dans une page cible et dans le secteur courant une page effacée à utiliser pour écrire une donnée.

Selon un mode de réalisation, le secteur à effacer reçoit un nombre d'étapes d'effacement partiel au maximum égal au nombre de pages auxiliaires que contient le secteur courant.

Selon un mode de réalisation, le procédé comprend, après effacement du secteur indisponible, une étape de rotation de secteurs comprenant les étapes consistant à déclarer comme secteur courant le secteur précédemment indisponible, déclarer comme secteur de sauvegarde le secteur précédemment courant, déclarer comme secteur de transfert le secteur précédemment de sauvegarde, et déclarer comme secteur indisponible le secteur précédemment de transfert.

Selon un mode de réalisation, le procédé comprend les étapes consistant à prévoir au moins un drapeau d'invalidation de page dans chaque page utile de la zone mémoire principale et de la zone mémoire auxiliaire, et invalider une page en portant le drapeau à une valeur logique de programmation.

Un mode de réalisation de l'invention se rapporte à une mémoire non volatile comportant des cellules mémoire devant être effacées avant d'être écrites, comme indiquée dans la revendication 12. Elle comprend une zone mémoire principale comprenant des pages cible, une zone mémoire auxiliaire comprenant des pages auxiliaires et présentant : un secteur courant comprenant des pages auxiliaires effacées utilisables pour écrire des données, un secteur de sauvegarde comprenant des pages auxiliaires contenant des données rattachées à des pages cible à effacer ou en cours d'effacement, un secteur de transfert comprenant des pages auxiliaires contenant des données à transférer dans des pages cible effacées, et un secteur indisponible comprenant des pages auxiliaires à effacer ou en cours d'effacement.

Selon un mode de réalisation, la mémoire comprend une unité de contrôle de l'écriture de données configurée pour, en réponse à une commande d'écriture d'une donnée dans une page cible, effectuer les actions suivantes : appliquer une étape d'effacement partiel aux pages auxiliaires du secteur indisponible et à des pages cible rattachées à des pages du secteur de sauvegarde ; transférer des données d'une page auxiliaire du secteur de transfert vers une page effacée de la zone mémoire principale, si la page auxiliaire est valide, et invalider la page auxiliaire ; écrire la donnée dans une page auxiliaire effacée du secteur courant, et invalider la page cible.

Selon un mode de réalisation, l'unité de contrôle est configurée pour, en réponse à une commande d'écriture d'une donnée dans une page cible : écrire la donnée dans seconde page auxiliaire effacée, si une donnée précédente de même adresse de page cible a déjà été écrite dans une première page auxiliaire, et invalider la première page auxiliaire.

Selon un mode de réalisation, les pages auxiliaires comprennent un champ d'adresse et l'unité de contrôle est configurée pour écrire dans le champ d'adresse d'une page auxiliaire l'adresse de page cible d'une donnée écrite dans une page auxiliaire.

Selon un mode de réalisation, l'unité de contrôle est configurée pour, en réponse à une commande d'écriture d'une donnée dans une page cible, écrire directement la donnée dans la page cible ou dans une page auxiliaire valide contenant une donnée précédemment écrite ayant la même adresse de page cible, si des cellules mémoire devant recevoir la donnée sont effacées dans la page cible ou dans la page auxiliaire.

Selon un mode de réalisation, l'unité de contrôle est configurée pour, avant d'écrire une donnée dans une page auxiliaire : lire un ensemble initial de données dans une page source, insérer la donnée à écrire dans l'ensemble initial de données, pour obtenir un ensemble de données mis à jour, puis écrire l'ensemble de données mis à jour dans la page auxiliaire.

Selon un mode de réalisation, l'unité de contrôle est configurée pour tenir à jour une table de correspondance entre des adresses de pages cible invalides et des adresses de pages auxiliaires valides, et, lorsqu'une donnée doit être lue dans une page cible, lire la donnée dans une page auxiliaire valide si l'adresse de la page auxiliaire valide existe dans la table de correspondance, sinon lire la donnée dans la page cible.

Selon un mode de réalisation, la mémoire comprend un pointeur de page auxiliaire pour désigner à la fois dans le secteur de transfert une page auxiliaire dont le contenu doit être transféré dans une page cible et dans le secteur courant une page effacée à utiliser pour écrire une donnée.

Selon un mode de réalisation, l'unité de contrôle applique au secteur à effacer un nombre d'étapes d'effacement partiel au maximum égal au nombre de pages auxiliaires que contient le secteur courant.

Selon un mode de réalisation, l'unité de contrôle est configurée pour, après avoir effacé le secteur indisponible : déclarer comme secteur courant le secteur précédemment indisponible, déclarer comme secteur de sauvegarde le secteur précédemment courant, déclarer comme secteur de transfert le secteur précédemment de sauvegarde, et déclarer comme secteur indisponible le secteur précédemment de transfert.

Selon un mode de réalisation, chaque page utile de la zone mémoire principale et de la zone mémoire auxiliaire comprend au moins un drapeau d'invalidation de page, et l'unité de contrôle est configurée pour invalider une page en portant le drapeau à une valeur logique de programmation.

Un mode de réalisation de l'invention concerne également un circuit intégré comprenant une mémoire telle que décrite ci-dessus.

Un mode de réalisation de l'invention concerne également une carte à puce ou étiquette électronique comprenant un circuit intégré comportant une mémoire telle que décrite ci-dessus.

Dans ce qui suit sera décrit un exemple de réalisation d'une mémoire selon l'invention et de mise en oeuvre d'un procédé d'écriture selon l'invention. La description ci-après est faite en se référant à titre non limitatif aux figures jointes parmi lesquelles :
- la figure 1 représente schématiquement un exemple de réalisation d'une mémoire selon l'invention,
- la figure 2 représente plus en détail la structure d'une zone mémoire principale et d'une zone mémoire auxiliaire représentées sous forme de bloc en figure 1,
- la figure 3 est un tableau décrivant l'utilisation de drapeaux de contrôle prévus dans la mémoire,
- la figure 4 représente une organisation en secteurs de la zone mémoire auxiliaire,
- la figure 5 illustre une étape de rotation des secteurs selon le procédé de l'invention,
- la figure 6 représente de façon plus détaillée un exemple d'architecture de mémoire conforme au schéma de la figure 1,
- les figures 7A, 7B sont des organigrammes décrivant des étapes du procédé selon l'invention,
- les figures 8A à 8H illustrent un cycle d'écriture-effacement selon l'invention, avec une page source dans la zone mémoire principale,
- les figures 9A à 9H illustrent un cycle d'écriture-effacement selon l'invention, avec une page source située dans un secteur de la zone mémoire auxiliaire,
- les figures 10A à 10C illustrent un cycle d'écriture-effacement selon l'invention, avec une page source située dans un autre secteur de la zone mémoire auxiliaire, et
- les figures 11A à 11F illustrent un cycle d'écriture-effacement selon l'invention, avec une page source située dans encore un autre secteur de la zone mémoire auxiliaire.

### A - Description générale de certains aspects de l'invention

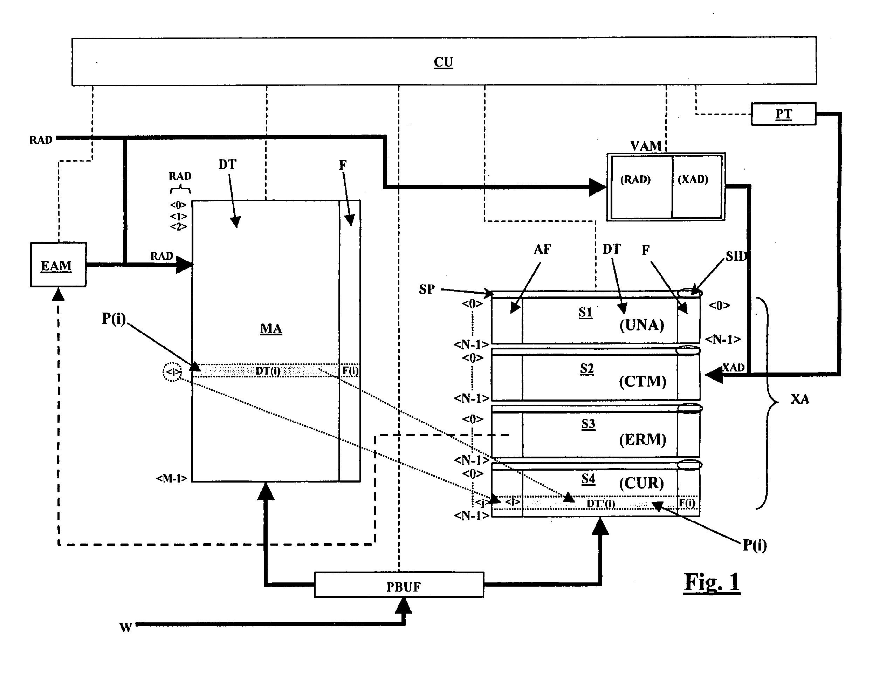

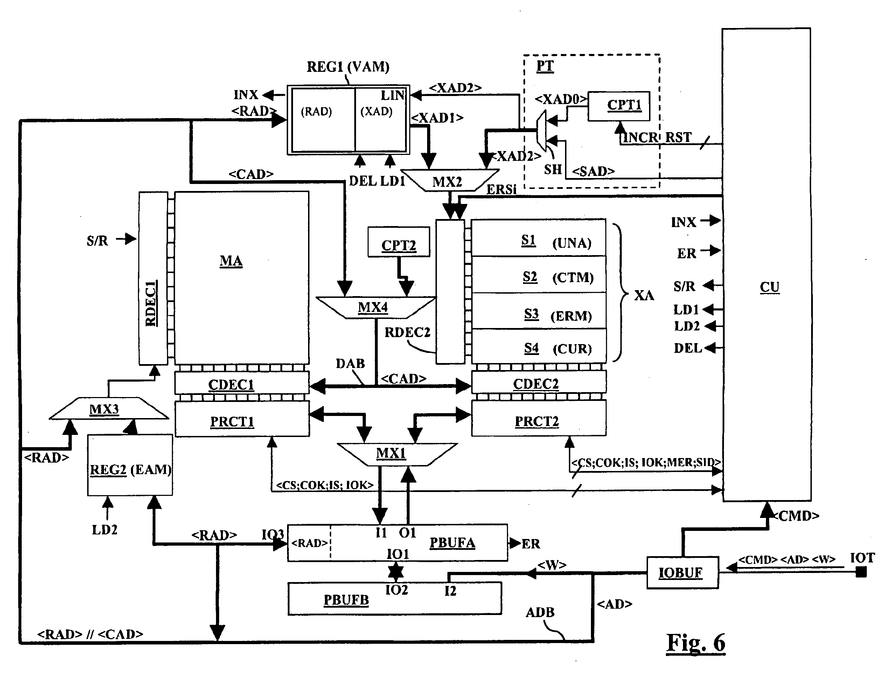

Il sera décrit dans ce qui suit plusieurs aspects de l'invention qui ont été regroupés dans un exemple de réalisation d'une mémoire selon l'invention représenté schématiquement sur la figure 1 et représenté plus en détail sur la figure 6. Toutefois, comme cela apparaîtra clairement à l'homme de l'art à la lecture de ce qui suit, chacun des aspects de l'invention est susceptible d'une mise en oeuvre propre pouvant conduire à des modes de réalisation différents de celui qui va être décrit.

La mémoire représentée sur la figure 1 comprend une zone mémoire principale MA ("Main Area"), ou "zone MA", et une zone mémoire auxiliaire XA, ou "zone XA". Les zones mémoire MA, XA sont du type non volatile et sont effaçables et programmables électriquement. Elles sont ici du type page-FLASH, c'est-à-dire divisées en pages effaçables individuellement ou effaçables par groupe de pages sélectionnées individuellement. Chaque page est divisée en segments pouvant être écrits individuellement et prévus pour recevoir chacun un mot binaire (par exemple un octet). La zone MA contient des pages cible et la zone XA contient des pages auxiliaires.

### i) Mise à jour de pages cible dans les pages auxiliaires

La zone XA est utilisée pour mettre à jour des pages cible, sans devoir effacer préalablement ces pages. Ainsi, en réponse à une commande d'écriture d'un ou plusieurs mots W dans une page cible P(i), les données de la page, après mise à jour, sont écrites dans la zone XA. La mise à jour des données de la page est effectuée dans un tampon de page PBUF : le contenu de la page cible P(i) est copié dans le tampon de page PBUF, puis le ou les nouveaux mots W sont insérés dans le tampon de page (les anciens mots étant écrasés). Le contenu mis à jour du tampon de page est ensuite écrit dans une page effacée de la zone XA, ou page d'arrivée, et la page cible est invalidée.

Une page auxiliaire peut être mise à jour de la même manière, si la page cible correspondante dans la zone MA est invalide. Le contenu de la page auxiliaire est dans ce cas placé dans le tampon PBUF, y est mis à jour, et est ensuite écrit dans une autre page auxiliaire, se trouvant dans l'état effacé. La page auxiliaire initiale est ensuite invalidée.

Ainsi, pour l'exécution d'une commande d'écriture dans une page cible, la page source (page dont le contenu doit être mise à jour) peut se trouver dans la zone MA ou dans la zone XA, tandis que la page d'arrivée se trouve dans la zone XA. Dans le premier cas, la page source est la page cible visée par la commande, tandis que dans le second cas la page source est une page auxiliaire rattachée à la page cible. On distinguera ainsi dans ce qui suit, dans un souci de clarification du langage, les termes suivants :
- page cible : page de la zone MA (notamment une page désignée par une commande),
- page source : page de la zone MA ou de la zone XA dont le contenu doit être mis à jour (une page source étant page cible si elle se trouve dans la zone MA),
- page d'arrivée : page dans laquelle les données la page source sont écrites après mise à jour.

La mise à jour d'une page source par transfert de ses données dans une page auxiliaire peut toutefois n'être pas nécessaire si la zone cible, c'est-à-dire le segment de la page source devant recevoir une nouvelle donnée, est dans l'état effacé. Ce point sera développé plus loin ("test de la zone cible").

### ii) Pages auxiliaires contenant un champ d'adresse

Les pages cible sont sélectionnées au moyen d'adresses RAD et les pages auxiliaires sont sélectionnées au moyen d'adresses XAD. La zone MA présente par exemple un champ d'adresse allant de 0 à M-1. Les pages cible et les pages auxiliaires comprennent chacune un champ de données DT. Selon un aspect de l'invention, les pages auxiliaires comportent en outre un champ d'adresse AF. Ce champ d'adresse reçoit l'adresse des pages cible auxquelles les pages auxiliaires sont associées, et permet d'écrire dans la zone XA le contenu mis à jour d'une page cible tout en conservant une information faisant le lien entre la page cible et la page auxiliaire, et assurant la traçabilité du transfert de contenu. Ainsi, lorsque les données contenues dans une page cible d'adresse <i> sont écrites, après mise à jour, dans une page de la zone XA, la page auxiliaire diffère de la page cible en ce qu'elle contient l'adresse <i> de la page cible dans son champ d'adresse AF et en ce qu'elle contient des données mises à jour.

Dans ce qui suit, il pourra ainsi être considéré dans un souci de simplification du langage qu'une page auxiliaire d'adresse physique <j> (adresse électrique) contenant l'adresse <i> dans son champ d'adresse est une page d'adresse <i>. De même, deux pages auxiliaires, ou plus, peuvent avoir la même adresse <i> qu'une page cible. L'adresse <i> est une adresse virtuelle s'agissant d'une page auxiliaire et une adresse physique s'agissant d'une page cible.

Une table d'adresses valides ou table VAM ("Valid Address Map") est prévue pour faire le lien entre les adresses RAD de pages cible ayant été mises à jour dans la zone XA, et les adresses physiques XAD des pages correspondantes de la zone XA. La table VAM est une table de correspondance qui reçoit des adresses RAD appliquées à la zone MA et les convertit automatiquement en adresses XAD. La table VAM ne comprend que des adresses XAD correspondant à des pages auxiliaires valides, les adresses des pages auxiliaires invalides étant supprimées en temps réel dans la table, de sorte qu'à chaque adresse XAD présente dans la table VAM correspond une adresse RAD et une seule. Par contre, à chaque adresse RAD présente dans la table ne correspond pas nécessairement une adresse XAD, si la page cible d'adresse RAD est valide.

### iii) Champs de contrôle

Selon un autre aspect de l'invention, les pages cible et les pages auxiliaires comprennent également un champ de contrôle F. Ainsi, une page P(i) d'adresse i dans la zone MA comporte un champ de données DT(i) et un champ de contrôle F(i), et une page P(i) d'adresse virtuelle i dans la zone XA comporte un champ d'adresse AF(i) contenant l'adresse physique <i>, un champ de données DT(i) et un champ de contrôle F(i).

Les champs de contrôle F de la zone MA et de la zone XA sont utilisés pour valider ou invalider les pages, en faisant en sorte que deux pages de même adresse <i> de la zone MA et de la zone XA, ou deux pages de même adresse <i> de la zone XA, ne soient pas valides en même temps. Ainsi, si des données valides DT(i) se trouvent dans une page auxiliaire P(i) au lieu de se trouver dans la page cible P(i) d'adresse <i>, la page cible est invalide tandis que la page auxiliaire est valide. De même, si deux pages auxiliaires ont la même adresse <i> dans leur champ d'adresse et sont ainsi rattachées à la même page cible, une seule page sur les trois peut être valide.

Les champs de contrôle sont également utilisés ici pour différencier une page entièrement effacée et une page valide ayant reçu des données.

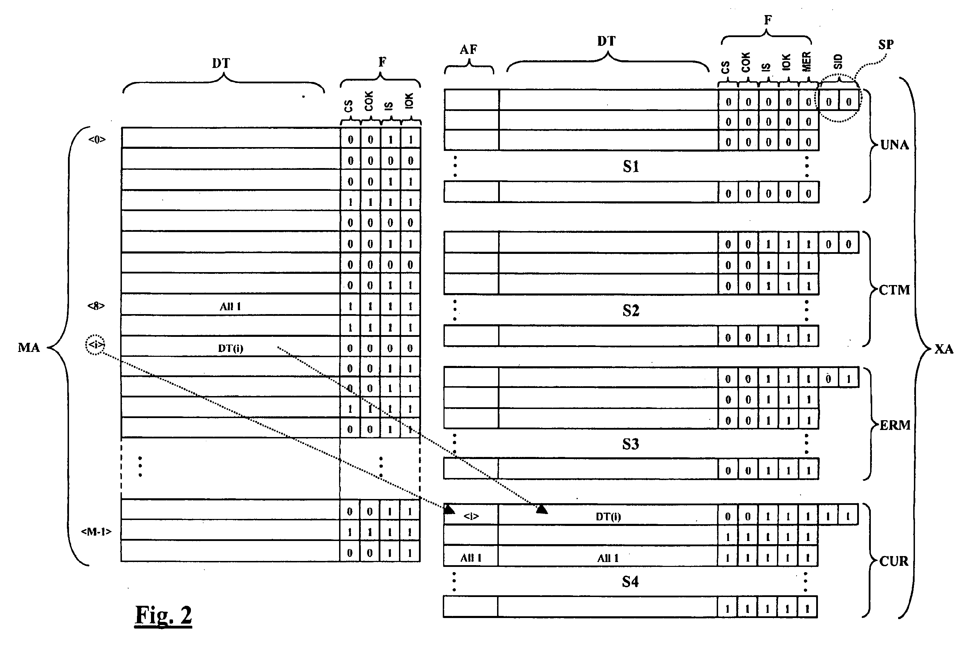

Un exemple de configuration des champs de contrôle F des zones MA, XA est illustré sur la figure 2. La figure 2 est une photographie du contenu des zones MA, XA à un instant quelconque. Les données qu'elles contiennent n'y sont pas représentées à l'exception de valeurs dans les champs de contrôle. Le champ de contrôle des pages auxiliaires comporte les drapeaux suivants :
- CS ("Copy Start"),
- COK ("Copy OK"),
- IS ("Invalidation Start"),
- IOK ("Invalidation OK"),
- MER ("Main Erased").
Le champ de contrôle des pages cibles comporte les drapeaux CS, COK, IS, IOK et ne comporte pas le drapeau MER.

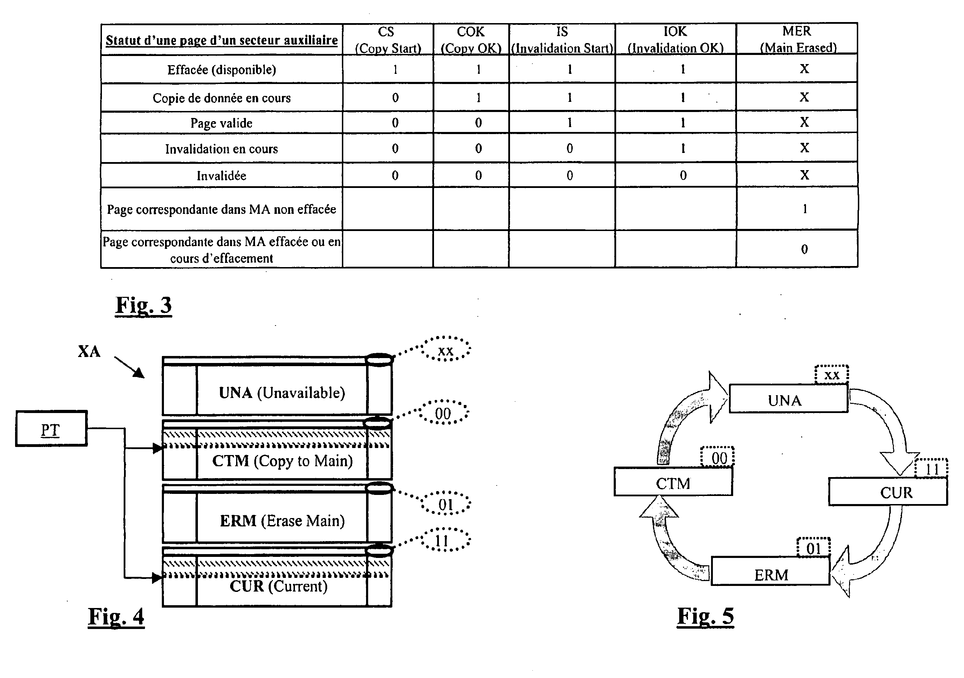

La figure 3 est un tableau montrant le codage du champ de contrôle des pages auxiliaires. Le codage du champ de contrôle des pages cible est identique à celui des pages auxiliaires en ce qui concerne les drapeaux CS, COK, IS, IOK. Chaque drapeau présente une valeur active qui est la valeur logique de programmation. La valeur logique de programmation dépend de la polarité conférée à des amplificateurs de lecture ("sense amplifiers") et est définie par convention. On considéra ici et dans ce qui suit que le "0" logique est la valeur logique de programmation (valeur d'un bit après écriture), le "1" logique étant ainsi la valeur logique d'effacement (valeur d'un bit effacé). La signification attribuée aux drapeaux est la suivante :
- le drapeau CS égal à 0 indique que des données vont être copiées dans la page,
- le drapeau COK égal à 0 indique que des données ont été copiées dans la page,
- le drapeau IS égal à 0 indique que la page va être invalidée,
- le drapeau IOK égal à 0 indique que la page est invalidée.

Par ailleurs, le drapeau MER égal à 0 indique que la page cible correspondante (page désignée par le champ d'adresse de la page auxiliaire considérée) est effacée ou est en cours d'effacement.

Les drapeaux CS, COK et IS sont prévus pour protéger la mémoire contre les conséquences d'une coupure d'alimentation intempestive. Le drapeau CS est mis à 0 au commencement d'une étape d'écriture et le drapeau COK est mis à 0 à la fin de l'étape d'écriture. Le drapeau IS est mis à 0 au commencement d'une étape d'invalidation et le drapeau IOK est mis à 0 à la fin de l'étape d'invalidation. Dans une application où la tension d'alimentation n'est pas susceptible de coupure intempestive, le drapeau IOK suffira pour définir le statut d'une page.

Une page de la zone MA ou de la zone XA peut ainsi présenter cinq statuts différents en fonction de la valeur du champ de contrôle :
- "Effacée" (soit "disponible") si CS/COK/IS/IOK = 1111
- "Copie de données en cours" si CS/COK/IS/IOK = 0111
- "Valide" si CS/COK/IS/IOK = 0011
- "Invalidation en cours" si CS/COK/IS/IOK = 0001
- "Invalidée" si CS/COK/IS/IOK = 0000

Comme une page n'est pas invalidée tant qu'elle n'a pas été utilisée au moins une fois pour écrire des données, des combinaisons de valeurs de drapeaux du type "1100" ou "1101" ne sont pas supposées exister.

A titre d'exemple, on a montré sur la figure 2 une page P(i) invalidée dans la zone MA et une page valide correspondante, de même adresse <i>, dans la zone XA. Par ailleurs une page cible effacée, par exemple la page d'adresse <8> en figure 2, ne comporte que des bits à 1 dans son champ de données DT ("All 1") et ne comporte que des drapeaux de contrôle à 1, ce qui signifie qu'elle est disponible. De même, une page auxiliaire effacée ne comporte que des bits à 1 ("All 1") dans son champ d'adresse AF et dans son champ de données DT et ne comporte que des drapeaux de contrôle à 1, ce qui signifie également qu'elle est disponible et n'est rattachée à aucune page cible.

### iv) Secteurs auxiliaires "tournants"

Selon un autre aspect de l'invention, la zone XA est divisée en quatre secteurs S1, S2, S3, S4 de même taille comprenant chacun N pages, comme montré sur les figures 1 et 2. Chaque secteur est adressable sur toute l'étendue de son champ d'adresse, allant de 0 à N-1. Chacun des secteurs S1 à S4 se voit attribuer à tour de rôle un statut particulier qui est indiqué par un champ SID ("identifiant de secteur") codé ici sur deux bits. Les bits du champ SID de chaque secteur sont ici enregistrés dans une page de service SP, ou page "non utile" (i.e. non utilisée pour stocker des données utilisateur), par exemple la première page de chaque secteur. Cette page n'est pas incluse dans le champ d'adresse allant de 0 à N-1 et est accessible au moyen d'un câblage particulier ou d'une adresse dédiée (sur les figures 2, 8A à 11F le champ SID est représenté dans le prolongement de la première page de chaque secteur, dans un souci de simplification des figures).

Les statuts attribués à tour de rôle à chaque secteur S1 à S4 sont les suivants :
- secteur "UNA" (pour "UNAVAILABLE") ou secteur indisponible,
- secteur "CUR" (pour "CURRENT") ou secteur courant,
- secteur "ERM" (pour "ERASE MAIN") ou secteur de sauvegarde, et
- secteur "CTM" (pour "COPY TO MAIN") ou secteur à transférer.

Comme indiqué sur la figure 4, le codage du champ SID est par exemple le suivant :
- secteur ayant le statut CTM : SID = 00,
- secteur ayant le statut ERM : SID = 01,
- secteur ayant le statut CUR : SID = 11

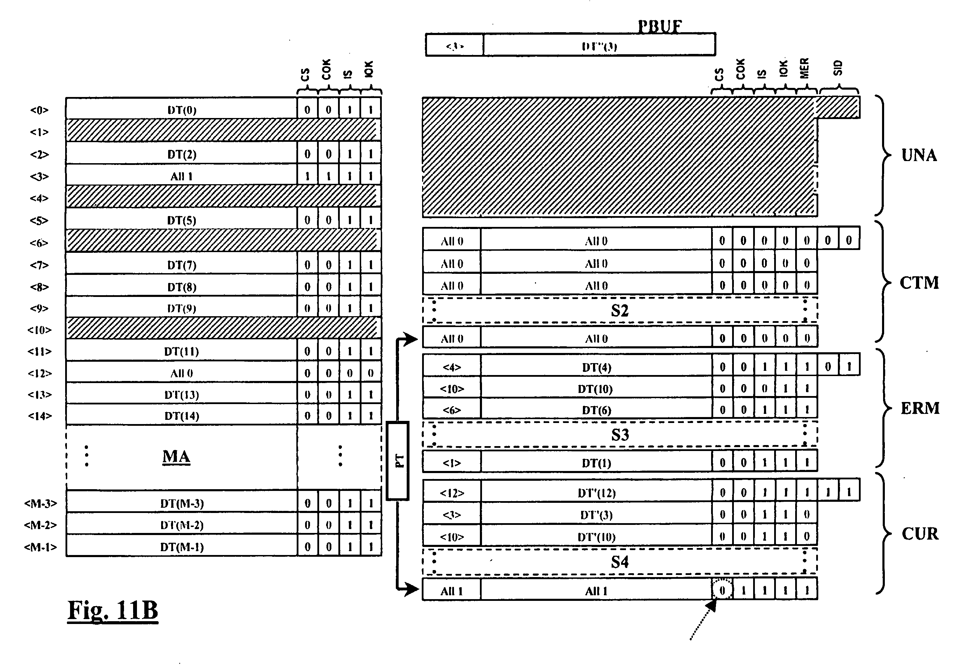

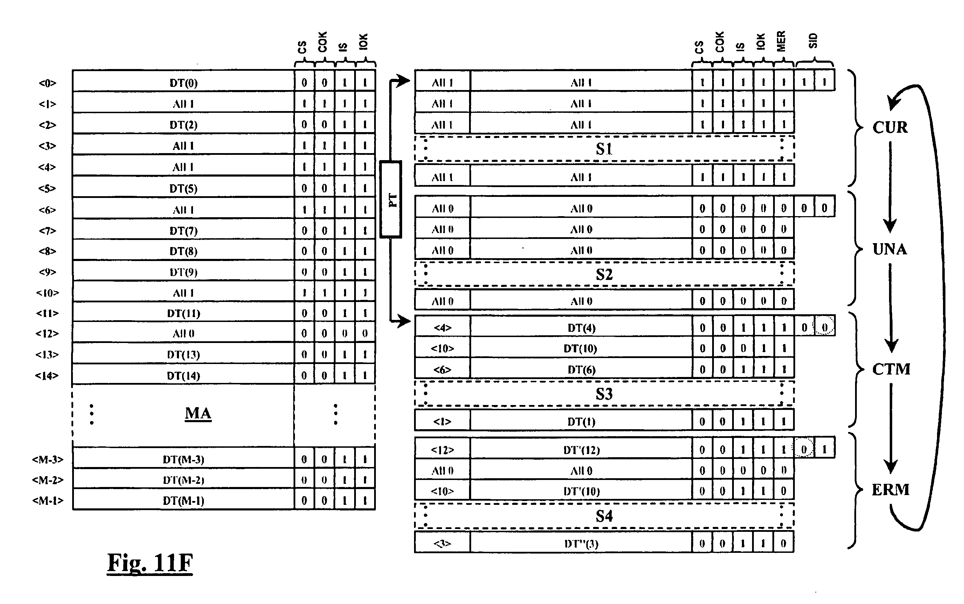

Le codage du statut UNA est indifférent ("xx") car l'attribution à tour de rôle de chacun des statuts à chacun des secteurs est effectuée en boucle dans l'ordre représenté sur la figure 5, à savoir: UNA, CUR, ERM, CTM, etc., de sorte qu'il existe toujours trois secteurs successifs CUR, ERM, CTM, le secteur UNA étant le secteur contigu suivant le secteur CTM et précédant le secteur CUR. Chaque secteur S1, S2, S3, S4 passe ainsi du statut UNA au statut CUR, puis du statut CUR au statut ERM, puis du statut ERM au statut CTM, puis du statut CTM au statut UNA, et ainsi de suite. Sur les figures jointes, à l'exception de la figure 11F, on considère à titre d'exemple que S1 est le secteur UNA, S2 est le secteur CTM, S3 est le secteur ERM et S4 le secteur CUR.

Le secteur ayant le statut UNA, ou "secteur UNA", est un secteur qui est effacé au cours d'une étape d'effacement selon l'invention. Cette étape comprend l'effacement simultané des pages auxiliaires du secteur UNA et de pages cible invalides dont les adresses sont mémorisées dans une table d'adresses à effacer, ou table EAM ("Erase Address Map"). Ainsi, au même moment, de l'espace mémoire est libéré dans la zone MA et de l'espace mémoire est libéré dans la zone XA. Le secteur UNA est indisponible tant pour recevoir des données que pour fournir des données. Il ne comprend que des pages ayant été précédemment invalidées avant que le statut UNA lui soit attribué. Les adresses de pages du secteur UNA ne figurent donc pas dans la table VAM. Après avoir été entièrement effacé, le secteur UNA se voit attribuer le statut CUR au cours d'une étape appelée "rotation des secteurs", étant précisé que les secteurs S1 à S4 sont immuables et que seul le statut qui leur est attribué fait l'objet de la rotation précitée.

Le secteur ayant le statut CUR, ou "secteur CUR", est le seul secteur de la zone XA utilisé pour écrire des données de page mises à jour. Ainsi, lorsqu'une page cible dans la zone MA doit être mise à jour dans la zone XA, la page d'arrivée est toujours une page du secteur CUR. Le secteur CUR peut également contenir une page à mettre à jour (page source). Dans ce cas, les données de la page source, après mise à jour dans le tampon de page PBUF, sont écrites dans une autre page de ce même secteur, puis la page source est invalidée et son adresse physique est remplacée dans la table VAM par l'adresse physique de l'autre page. De façon générale, les pages valides du secteur CUR correspondent à des pages cible effacées ou à effacer, ou à des pages cible invalidées. Lorsque toutes les pages du secteur CUR ont été utilisées (i.e. ont été écrites), le secteur CUR se voit attribuer le statut ERM au cours de l'étape de rotation des secteurs.

Le secteur ayant le statut ERM, ou "secteur ERM", a une double fonction. D'une part, son champ d'adresse pointe vers des pages cible qui sont à effacer ou en cours d'effacement. Ces adresses sont stockées dans la table EAM au commencement de l'étape d'effacement (après l'étape de rotation des secteurs) en lisant toutes les adresses présentes dans le champ d'adresse des pages valides du secteur ERM. Ainsi la table EAM ne reçoit que des adresses de pages désignées par des pages valides du secteur ERM et dont le drapeau MER n'est pas égal à 0 (le drapeau MER étant prévu pour éviter d'effacer inutilement des pages qui sont déjà effacées). En d'autres termes, les pages invalides du secteur ERM, ainsi que les pages valides dont le drapeau MER est égal à 0, ne sont pas prises en compte pour désigner les pages de la zone MA devant être effacées. D'autre part, le secteur ERM a aussi pour fonction de sauvegarder des données que ses pages valides contiennent, pendant que les pages correspondantes dans la zone MA, vers lesquelles elles pointent, sont en cours d'effacement. Enfin, bien que le secteur ERM soit indisponible pour recevoir des données, il peut contenir une page à mettre à jour (page source). Dans ce cas, la page source, après mise à jour, est écrite dans une page du secteur CUR, la page source dans le secteur ERM est invalidée et son adresse est remplacée dans la table VAM par l'adresse physique de la page dans le secteur CUR. Lorsque les pages de la mémoire MA vers lesquelles pointent les pages valides du secteur ERM ont été effacées, le secteur ERM se voit attribuer le statut CTM au cours de l'étape de rotation des secteurs.

Le secteur ayant le statut CTM, ou "secteur CTM", contient des pages qui sont à transférer dans la zone MA si ces pages sont valides. Toutes les pages valides du secteur CTM pointent vers des pages effacées de la zone MA, puisque le secteur CTM avait précédemment le statut ERM. Quand une page a été transférée dans la zone MA, la page est invalidée et l'adresse qu'elle contient est retirée de la table VAM. Le secteur CTM est indisponible pour recevoir des données mais peut contenir une page à mettre à jour (page qui n'a pas encore été transférée dans la zone MA). Dans ce cas, les données de page, après mise à jour, sont écrites dans une page du secteur CUR, la page source dans le secteur CTM est invalidée et l'adresse qu'elle contient est retirée de la table VAM. Le drapeau MER de la page d'arrivée est mis à 0 pour indiquer que la page correspondante dans la zone MA est entièrement effacée. La page source, après avoir été invalidée, n'est pas transférée dans la zone MA. Lorsque toutes les pages valides du secteur CTM ont été transférées dans la zone MA, le secteur CTM ne comprend que des pages invalides et se voit attribuer le statut de secteur UNA au cours de l'étape de rotation des secteurs.

En résumé, la structure en quatre secteurs de la zone XA permet de gérer trois opérations distinctes :
- l'effacement des pages auxiliaires (pages du secteur UNA) et de pages cible (pages désignées par les pages du secteur ERM),
- le transfert de pages auxiliaires valides (page du secteur CTM) dans des pages cible effacées, et
- la mise à jour de pages de la zone MA ou de la zone XA (pages du secteur CUR, ERM ou CTM) dans des pages du secteur CUR.

L'étape d'effacement des pages peut comprendre classiquement l'application d'impulsions d'une haute tension d'effacement (typiquement 10 à 15 V) aux cellules mémoire concernées, tandis que les cellules mémoire des pages de la zone MA ne devant pas être effacées reçoivent une tension d'inhibition d'effacement. En ce qui concerne la zone XA, une formation des secteurs sur des substrats différents permet d'isoler les secteurs CTM, ERM, CUR de la tension d'effacement appliquée au secteur UNA. Il pourrait néanmoins être prévu de réaliser les quatre secteurs sur un même substrat, les secteurs S1 à S4 étant alors des secteurs logiques et non des secteurs physiques.

### v) Effacement en plusieurs étapes

Selon encore un autre aspect de l'invention, l'étape d'effacement est une étape d'effacement partiel et plusieurs étapes d'effacement partiel sont nécessaires pour obtenir l'effacement complet du secteur UNA et des pages de la zone MA désignées par le secteur ERM. Dans le cadre du présent mode de réalisation, le nombre d'étapes d'effacement partiel pour obtenir l'effacement complet de cellules mémoire est au maximum égal au nombre N de pages du secteur CUR, la valeur optimale étant N étapes d'effacement partiel.

Chaque étape d'effacement partiel est une étape d'effacement en soi classique mais de durée inférieure à celle d'une étape d'effacement classique, et plus particulièrement de durée égale à T/N si T est la durée moyenne d'une étape d'effacement complet. L'étape d'effacement partiel selon l'invention est ainsi appliquée pendant une durée T/N aux pages du secteur UNA et aux pages de la zone MA désignées par le champ d'adresse des pages valides du secteur ERM dont le drapeau MER n'est pas à 0. Si l'effacement est effectué par impulsions (technique couramment utilisée pour effacer des mémoires Flash), le nombre d'impulsions d'effacement appliqué aux cellules mémoire pendant une étape d'effacement partiel est égal à P/N si P est le nombre moyen d'impulsions de haute tension d'effacement pour obtenir un effacement complet des cellules mémoire. Les étapes d'effacement partiel peuvent être contrôlées comme l'est une étape d'effacement classique et peuvent comprendre, dans ce cas, une étape de contrôle du niveau de charges électriques dans les cellules mémoire (consistant à lire les cellules mémoire avec une tension de lecture intermédiaire) afin de cesser l'application des impulsions d'effacement lorsque cela n'est plus nécessaire. Dans ce cas, la dernière étape d'effacement partiel peut comprendre moins de P/N impulsions si l'étape de contrôle montre qu'il n'est pas nécessaire d'effacer plus avant les cellules mémoire.

### vi) Cycle d'écriture-effacement

La présente invention prévoit avantageusement un procédé d'écriture de données qui regroupe, dans un cycle dit "d'écriture-effacement", les opérations précitées d'effacement partiel, de transfert de pages valides du secteur CTM dans des pages effacées de la zone MA, et d'écriture de données mises à jour dans le secteur CUR. Afin de simplifier la mise en oeuvre de ce cycle d'écriture-effacement, et comme montré schématiquement sur la figure 4, un pointeur d'adresse PT est utilisé pour désigner, à chaque cycle d'écriture-effacement :
- dans le secteur CTM, la page à transférer dans la zone MA,
- dans le secteur CUR, la page à utiliser pour écrire des données de page mises à jour.

Si la page désignée par le pointeur dans le secteur CTM n'est pas valide, la copie n'est pas effectuée et le cycle d'écriture-effacement ne comprend que l'étape d'effacement partiel et l'étape d'écriture. Ainsi, chaque fois qu'une donnée doit être écrite, deux ou trois des étapes suivantes sont réalisées :
- des pages de la zone MA et des pages de la zone XA (pages du secteur UNA) sont partiellement effacées,
- une page située dans le secteur CTM est transférée "en l'état" (i.e. sans mise à jour) dans la zone MA (si cette page est valide), puis cette page est invalidée,
- le contenu d'une page source est transféré dans le secteur CUR, après avoir été mis à jour, puis la page source est invalidée.

Les pages de la zone MA et de la zone XA ne sont totalement effacées qu'après N cycles d'effacement partiel, soit après que N pages du secteur CUR ont été écrites, ceci nécessitant ensuite de déclencher l'étape de rotation de secteurs. Après rotation des secteurs, l'ancien secteur UNA entièrement effacé est utilisé en tant que secteur CUR. Pendant un cycle complet d'utilisation du secteur CUR et jusqu'à l'étape de rotation des secteurs suivante, le pointeur progresse de 0 à N-1 et est incrémenté d'une unité à chaque cycle d'écriture-effacement. Il est remis à zéro à chaque étape de rotation des secteurs.

Ce procédé de type "pipe line" offre plusieurs avantages. D'une part il permet d'assurer une mise à disposition permanente de nouvelles pages effacées de la zone XA pour écrire des données de page mises à jour. D'autre part, il réduit d'un facteur N la durée apparente d'effacement des pages, puisque l'étape d'effacement partiel appliquée aux pages concernées entre deux écritures de données est de durée N fois inférieure à la durée d'une étape d'effacement complète. Enfin, l'étape d'effacement partiel "en continu" ne nécessite pas d'interrompre la réception de commandes d'écriture. Si le temps d'écriture des cellules mémoire est par exemple de 5 microsecondes, et le temps d'effacement de 100 millisecondes, le temps d'effacement apparent est de 1 milliseconde si N = 100, chaque secteur de la zone XA comprenant alors 100 pages.

### B - Exemple de réalisation de la mémoire

Dans la mémoire représentée schématiquement sur la figure 1, la table EAM, la table VAM, le pointeur d'adresse PT ainsi que le tampon de page PBUF sont contrôlés par une unité de contrôle CU à logique câblée (machine d'état) ou à microprocesseur. Le procédé d'écriture selon l'invention est mis en oeuvre sous forme d'algorithme exécuté par l'unité CU.

La figure 6 représente un exemple de réalisation détaillé du schéma de la figure 1. En sus des éléments représentés sur la figure 1, la mémoire comprend des éléments décrits ci-après.

### i) Entrée/sortie et bus d'adresse

La mémoire comporte un tampon d'entrée/sortie IOBUF relié à une borne d'entrée/sortie IOT. Ce tampon permet à la mémoire de recevoir des commandes CMD de lecture ou d'écriture accompagnées d'adresses de mot AD, les commandes d'écriture étant également accompagnées d'un ou de plusieurs mots W à écrire. L'adresse d'un mot AD comprend une adresse de ligne RAD (bits d'adresse de poids fort) et une adresse de colonne CAD (bits d'adresse de poids faible). L'adresse de ligne RAD est l'adresse d'une page cible dans la zone MA et l'adresse de colonne CAD est l'adresse du segment où se trouve le mot dans la page cible ou dans la page source correspondante. Un bus d'adresse ADB véhicule des adresses de page RAD qui sont lues dans les pages auxiliaires ou qui accompagnent des commandes, ainsi que des adresses de colonne CAD accompagnant des commandes.

### ii) Décodeurs et circuits de lecture et d'écriture

Un décodeur de ligne RDEC1 permet de sélectionner des pages dans la zone MA en lecture, écriture ou effacement, et un décodeur de colonne CDEC1 permet de sélectionner des mots à lire ou écrire dans des pages sélectionnées de la zone MA. Un circuit PRCT1 assure l'écriture et la lecture de la zone MA et comprend des amplificateurs de lecture et des verrous de programmation (non représentés) pour lire ou écrire un mot sélectionné dans une page. Un décodeur de ligne RDEC2 permet de sélectionner des pages dans la zone XA en lecture ou écriture, et un décodeur de colonne CDEC2 de sélectionner des mots à lire ou écrire dans des pages sélectionnées de la zone XA. De façon similaire, un circuit PRCT2 assure l'écriture et la lecture de la zone XA et comprend des amplificateurs de lecture et des verrous de programmation pour lire ou écrire au moins un mot ou le champ d'adresse d'une page sélectionnée.

Les circuits PRCT1, PRCT2 sont configurés pour permettre à l'unité de contrôle CU de lire ou d'écrire les drapeaux CS, COK, IS, IOK (pages de la zone MA ou XA), MER (pages de la zone XA) ainsi que le champ SID (pages de service de la zone XA). En mode lecture, les drapeaux sont lus automatiquement par des amplificateurs de lecture supplémentaires prévus à cet effet et sont envoyés à l'unité de contrôle. En mode écriture, des verrous de programmation spécifiques permettent à l'unité de contrôle de modifier individuellement la valeur de chaque drapeau.

Le décodeur RDEC2 comporte quatre étages de décodage SS1, SS2, SS3, SS4 et reçoit, par l'intermédiaire d'un multiplexeur MX2, une adresse de page XAD1 fournie par la table VAM ou une adresse de page XAD2 fournie par le pointeur PT, ces adresses étant valables en lecture et en écriture seulement. En mode effacement, les pages du secteur à effacer (secteur UNA) sont sélectionnées par le décodeur RDEC2 sur réception d'un signal ERSi qui peut présenter quatre valeurs ESR1, ESR2, ESR3, ERS4, soit une valeur par secteur à sélectionner en effacement. L'application du signal ERSi inhibe la sélection de pages au moyen des adresses XAD1 ou XAD2.

### ii) Pointeur PT

Le pointeur PT comprend un compteur CPT1 de type volatile et un circuit SH de concaténation de bits d'adresse de poids fort et de bits d'adresse de poids faible, formant également un tampon de sortie du pointeur PT. Plus particulièrement, l'adresse XAD2 fournie par le pointeur PT est le résultat de la concaténation d'une adresse XAD0 fournie par le compteur CPT1 et d'une adresse de poids fort, formant une adresse de secteur SAD, fournie par l'unité de contrôle CU, les deux adresses étant appliquées au circuit SH. L'adresse XAD0 est ainsi une adresse de page au sein du secteur sélectionné et va de 0 à N-1. Ainsi, avec la même adresse XAD0 fournie par le compteur CPT1, l'unité de contrôle peut sélectionner des pages de même adresse de poids faible dans les secteurs CTM et CUR, en changeant seulement l'adresse de secteur SAD.

Après une étape de rotation des secteurs, l'unité de contrôle met le compteur CPT1 à 0 pour que le pointeur fournisse l'adresse de la première page courante du secteur CTM à transférer dans la zone MA (si cette page est valide) ou l'adresse de la première page courante effacée du secteur CUR devant recevoir des données mises à jour, selon l'adresse de secteur SAD qui lui est appliquée. L'unité de contrôle incrémente ensuite le compteur au moyen d'un signal INCR, à chaque cycle d'écriture-effacement suivant.

Après une étape de rotation des secteurs et avant démarrage du premier cycle d'écriture-effacement, le pointeur PT est également utilisé par l'unité de contrôle pour charger dans la table EAM les adresses de pages à effacer dans la zone MA. A cet effet le compteur CPT1 est mis à 0 et le secteur ERM est sélectionné en lecture. Les champs d'adresse des pages du secteur sont lus et sont transférés dans la table EAM. Les champs de contrôle des pages étant automatiquement lus par le circuit PRCT2, l'unité de contrôle ne charge dans la table EAM que les adresses lues dans des pages valides et dont le drapeau MER n'est pas égal à 0.

### iv) Table VAM

La table VAM est gérée dans un registre REG1 volatile qui comprend une entrée de pointage reliée au bus d'adresse ADB pour recevoir l'adresse RAD présente sur le bus, et une sortie reliée au décodeur RDEC2 via le multiplexeur MX2. Le registre REG1 contient une liste d'adresses RAD préenregistrée et, en face de cette liste, une liste d'adresses XAD qui est initialement vide, l'ensemble formant la table VAM. A une adresse RAD de la table correspond un emplacement pour recevoir une adresse XAD. Lorsqu'une adresse RAD se trouve sur le bus et est vue par l'entrée de pointage, le registre se positionne automatiquement sur cette adresse dans la table et fournit l'adresse XAD correspondante (désignée XAD1 sur la figure 6) si l'emplacement n'est pas vide. Le registre met alors à 1 un signal INX qui indique à l'unité de contrôle qu'une page valide d'adresse RAD se trouve dans la zone XA. Si l'emplacement en face de l'adresse RAD est vide dans la table VAM, le signal INX reste à 0. Ce signal permet ainsi à l'unité de contrôle de savoir quel circuit de lecture PRCT1, PRCT2 elle doit activer.

Le registre REG1 comprend également une entrée de chargement LIN qui reçoit l'adresse XAD2 fournie par le pointeur PT. Lorsque l'unité de contrôle veut associer une adresse déterminée XAD2 fournie par le pointeur PT à une adresse déterminée RAD présente sur le bus ADB, l'unité de contrôle applique un signal de chargement LD1 au registre REG1 et l'adresse présente sur l'entrée LIN est enregistrée dans la table VAM, en face de l'adresse RAD sélectionnée par l'entrée de pointage. Inversement, lorsque l'unité de contrôle veut supprimer une adresse XAD dans la table VAM, elle applique un signal d'effacement DEL au registre.

### v) Tampon de page PBUF

Le tampon de page comprend ici deux tampons PBUFA, PBUFB, la mise à jour des pages étant assurée par le tampon PBUFB. Le tampon PBUFA comporte une entrée I1 reliée à des sorties des circuits PRCT1, PRCT2 via un multiplexeur MX1, pour recevoir un mot lu dans l'une des zones MA, XA, ou une page entière lue mot à mot, ainsi que le champ d'adresse d'une page auxiliaire. Le tampon PBUFA émet un signal ER lorsqu'un mot chargé dans le tampon a tous ses bits égaux à 1 (mot effacé). Ce signal est également mis à 1 lorsque tous les mots d'une page ont été chargés dans le tampon PBUFA et que la page ne contient que des bits à 1 (page effacée). Le signal ER est par exemple le résultat de la fonction ET de tous les bits présents dans le tampon PBUFA, lesquels sont mis par défaut à 1 après réinitialisation du tampon.

Le tampon PBUFA comporte également une sortie O1 reliée à des entrées des circuits PRCT1, PRCT2 via le multiplexeur MX1, pour charger dans les circuits PRCT1, PRCT2 un mot à écrire dans les zones MA, XA, ou charger dans le circuit PRCT2 un champ d'adresse à écrire dans la zone XA. Il comporte également une entrée/sortie I02 reliée à une entrée/sortie I/O du tampon PBUFB, pour transférer son contenu dans ce second tampon ou recevoir le contenu de ce second tampon. Le tampon PBUFA comporte également une entrée/sortie IO3 reliée à la table VAM ainsi qu'au bus d'adresse ADB, pour fournir des adresses RAD lues dans des champs d'adresse de pages auxiliaires ou au contraire charger dans le tampon une adresse présente sur le bus et devant être écrite dans le champ d'adresse d'une page auxiliaire.

Le tampon PBUFB comporte une deuxième entrée I2 reliée au tampon IOBUF pour recevoir un ou plusieurs mots W à écrire dans la mémoire. Le tampon PBUFB met à jour le contenu d'une page fourni par le tampon PBUFA en y insérant le ou les mots fournis par le tampon IOBUF, son entrée/sortie IO2 permettant de replacer dans le tampon PBUFA les données de page mises à jour.

### vi) Table EAM

La table EAM est gérée par un registre volatile REG2 ayant une entrée reliée à l'entrée/sortie I03 du tampon PBUFA, pour recevoir des adresses de pages à effacer lues dans le secteur ERM, en réponse à un signal de chargement LD2 émis par l'unité de contrôle. Une sortie du registre REG2 est appliquée sur une entrée d'adresse du décodeur RDEC1 par l'intermédiaire d'un multiplexeur MX3 dont l'autre entrée est reliée au bus d'adresse. En mode lecture, l'unité de contrôle utilise le multiplexeur MX3 pour appliquer au décodeur RDEC1 l'adresse RAD présente sur le bus. En mode effacement, l'unité de contrôle relie la sortie du registre REG2 au décodeur RDEC1.

Le décodeur RDEC1 comprend des verrous de lignes de mot (non représentés) pour sélectionner des pages dont les adresses figurent dans table EAM. A cet effet le registre REG2 est lu adresse après adresse. A chaque adresse lue, l'unité de contrôle applique au décodeur RDEC1 un signal S/R (Set/Reset) pour verrouiller la sélection de la page correspondante. Une fois que toutes les pages désignées par la table EAM sont sélectionnées, la tension d'effacement peut leur être appliquée collectivement, les pages non sélectionnées recevant une tension d'inhibition d'effacement.

### vii) Balayage d'adresses de mot au sein d'une page sélectionnée

L'adresse de colonne CAD fournie par le tampon IOBUF est appliquée aux décodeurs CDEC1, CDEC2 par l'intermédiaire d'un multiplexeur MX4 dont l'autre entrée est reliée à la sortie d'un compteur d'adresse CPT2. Lorsqu'un mot d'adresse CAD doit être lu ou écrit dans une page sélectionnée, l'unité de contrôle applique l'adresse CAD aux décodeurs CDEC1, CDEC2 et active l'un de ces décodeurs. Lorsqu'une page entière doit être lue, l'unité de contrôle relie la sortie du compteur CPT2 aux décodeurs CDEC1, CDEC2, met le compteur à 0 et balaye tout le champ d'adresse de colonne pour lire les mots les uns après les autres, le résultat de la lecture étant chargé dans le tampon PBUFA.

### C - Initialisation de la mémoire

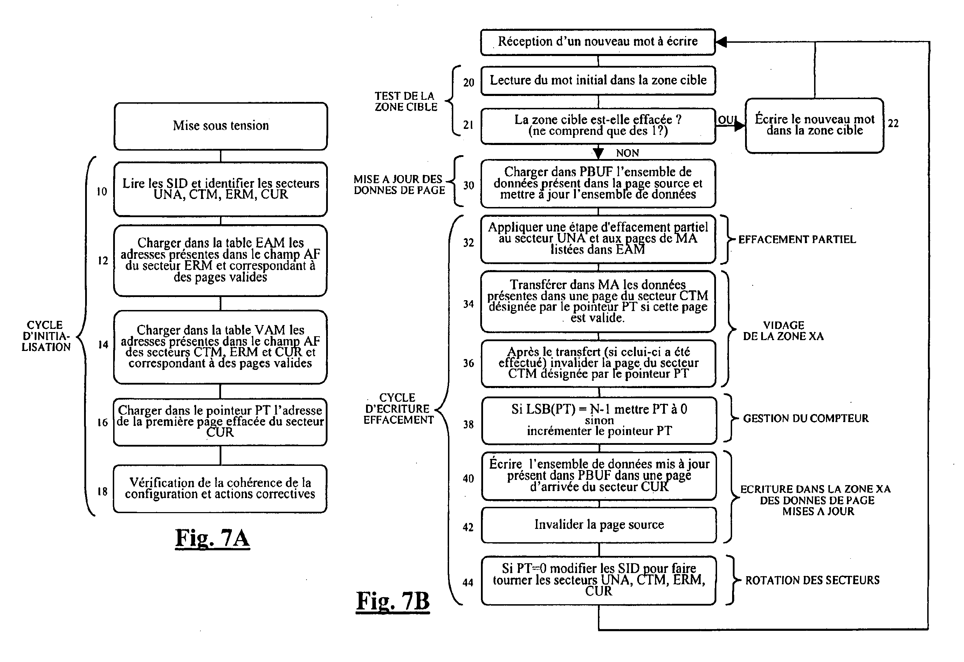

L'organigramme en figure 7A décrit un cycle d'initialisation de la mémoire après sa mise sous tension, qui suit une mise hors tension volontaire ou accidentelle. Les tables VAM et EAM, ainsi que le pointeur PT étant des données volatiles, leur contenu est régénéré par l'unité de contrôle à partir des informations se trouvant dans le zones MA et XA. On distingue les étapes suivantes.

### i) Identification des secteurs (étape 10)

L'unité de contrôle lit les champs SID dans les pages de service et identifie les secteurs UNA, CTM, ERM, CUR. Comme indiqué plus haut le secteur UNA est identifié par défaut comme étant le quatrième secteur suivant les secteurs présentant successivement des SID égaux à 11, 01 et 00 (Cf. fig. 5).

### ii) Mise à jour de la table EAM (étape 12)

Cette étape est identique à celle effectuée après une rotation de secteurs. Les champs d'adresse sont lus dans le secteur ERM et sont chargés dans le registre REG2 via le tampon PBUFA, s'ils appartiennent à des pages valides et si le drapeau MER de ces pages n'est pas à 0. Après une coupure d'alimentation, un cycle complet d'effacement est appliqué par sécurité aux pages désignées par le secteur ERM.

### iii) Mise à jour de la table VAM (étape 14)

La table VAM est régénérée en lisant dans les secteurs CTM, ERM et CUR les pages valides et en enregistrant simultanément dans le registre REG1 les adresses physiques XAD de ces pages. Afin que le registre REG1 pointe sur la bonne adresse RAD lorsqu'une adresse XAD est enregistrée dans la partie droite de la table VAM (Cf. fig. 6) l'adresse lue dans le champ d'adresse de chaque page valide est appliquée sur le bus d'adresse ADB via le tampon PBUFA (Cf. fig. 6) et se retrouve ainsi à l'entrée du registre REG1. Il convient de noter que ces adresses correspondent, dans la zone MA, à des pages effacées ou invalidées. Plus particulièrement :
- les pages valides du secteur CUR correspondent à des pages effacées ou invalidées de la zone MA,
- les pages valides du secteur CTM correspondent à des pages déjà effacées de la zone MA,
- les pages valides du secteur ERM dont le drapeau ER n'est pas à 0 correspondent à des pages de la zone MA qui étaient en cours d'effacement au moment de la coupure d'alimentation électrique.

### vi) Mise à jour du pointeur PT (étape 16)

L'unité de contrôle doit trouver ici la première page effacée du secteur CUR. Pour trouver cette première page après une coupure d'alimentation électrique, le compteur CPT1 est mis à zéro au moyen du signal RST et le secteur CUR est lu page par page en incrémentant le compteur jusqu'à ce qu'une page effacée soit trouvée. L'adresse de poids faible de cette page est alors laissée dans le compteur CPT1 pour générer l'adresse XAD2 fournie par le pointeur PT. Il convient de noter qu'une page du secteur CUR est considérée comme n'étant pas dans l'état effacé dès lors que le drapeau CS est égal à 0 et même si le drapeau COK est à 1. Cela signifie en effet que la page a commencé à être écrite avant la coupure d'alimentation électrique.

### v) Contrôle de cohérence (étape 18)

La mémoire est protégée contre les coupures de tension accidentelles grâce aux redondances de drapeaux CS/COK et IS/IOK qui permettent de tracer pas à pas des étapes de traitement intermédiaires comme le commencement de l'écriture d'une page et la fin de l'écriture de la page, ou le commencement de l'invalidation d'une page et la fin de l'invalidation de la page, de sorte qu'à la mise sous tension l'unité de traitement peut identifier sans ambiguïté les pages valides et les pages invalides, les processus inachevés et les conflits éventuels. Le contrôle de cohérence repose sur une analyse des incohérences entre les drapeaux. Par exemple, si une page était en cours d'écriture au moment de la coupure d'alimentation, la page présente le drapeau CS à 0 mais le drapeau COK est à 1. Les données de la page ne sont donc pas valables et l'unité de contrôle recherche la page invalide de même adresse (physique ou virtuelle) afin de retrouver les anciennes données de la page, de sorte que seule la mise à jour a été perdue. Diverses étapes de contrôle de cohérence et actions correctives correspondantes peuvent être prévues et ne seront pas décrites ici dans un souci de simplicité.

### D - Ecriture d'une donnée dans la mémoire

La figure 7B est un organigramme décrivant un exemple de réalisation du procédé d'écriture selon l'invention, en réponse à une commande d'écriture d'un mot W dans une page P(i) d'adresse <i>.

Le procédé comprend une étape de test de la zone cible (segment de la page source devant recevoir le mot), une étape de mise à jour des données de page, puis le cycle d'écriture-effacement selon l'invention.

### i) Test de la zone cible

Le test de la zone cible est prévu pour éviter d'engager le cycle d'écriture-effacement si la zone cible est dans l'état effacé, ce qui peut être le cas lorsque la page cible est entièrement effacée ou lorsque des données ont été écrites dans d'autres segments de la page visée mais pas dans la zone cible elle-même.

Le contenu de la zone cible est lu à l'adresse indiquée par la commande (étape 20). La zone cible peut être située dans la zone MA (la page source est la page cible) ou dans la zone XA (la page source est différente de la page cible). La sélection de la zone approprié MA ou XA est faite automatiquement par la table VAM et le signal INX indique à l'unité de contrôle quel circuit de lecture elle doit activer. L'unité de contrôle examine ensuite le signal ER fourni par le tampon PBUFA (étape 21). Si ce signal est égal à 1, l'unité de contrôle écrit le mot dans la zone cible (étape 22) puis revient à une étape d'attente d'une nouvelle commande. Si le signal ER est égal à 0, cela signifie que la zone cible n'est pas effacée et ne peut pas être écrite. L'unité de contrôle passe alors à l'étape de mise à jour des données de page, décrite ci-après.

### ii) Mise à jour des données de page

Tous les mots contenus dans la page source sont chargés dans le tampon PBUFA, en utilisant le compteur CPT2 pour effectuer le balayage des adresses de colonne CAD. L'adresse de la page cible présente sur le bus d'adresse est également chargée dans le tampon PBUFA. Le tampon comprend ainsi un ensemble de données initial et l'adresse de la page cible. Le contenu du tampon PBUFA est transféré dans le tampon PBUFB. Ce dernier y incorpore le mot à écrire et écrase le mot initial (étape 30) sans modifier les autres mots de la page.

### iv) Cycle d'écriture-effacement

Le cycle d'écriture-effacement selon l'invention comprend les trois étapes décrites plus haut, et des étapes de gestion du pointeur PT.

Etape 32 : L'unité de contrôle applique une étape d'effacement partiel au secteur UNA et aux pages de la zone MA listées dans la table EAM, après avoir transféré dans le décodeur RDEC1 les adresses présentes dans la table EAM et verrouillé la sélection des pages correspondantes.

Etape 34 : L'unité de contrôle doit transférer dans la zone MA les données présentes dans une page du secteur CTM désignée par le pointeur PT. A cet effet, l'unité de contrôle applique au pointeur PT une adresse de secteur SAD correspondant au secteur CTM et analyse d'abord le champ de contrôle de la page pour déterminer si elle est valide.

Si la page n'est pas valide, aucun transfert n'est effectué. Si la page n'est pas valide mais ne contient pas que des données égales à 0 (ancienne page source qui n'a pas été mise à 0 pour préserver son champ d'adresse, voir étape 42), l'unité de contrôle met toutes les données de page à 0 y compris les drapeaux et le champ d'adresse. Cette mise à zéro des données de la page invalide est optionnelle et n'est prévue qu'en relation avec la gestion des niveaux de charges électriques dans certains types de cellules mémoire, afin que le processus d'effacement soit appliqué à des cellules mémoire se trouvant dans le même état électrique. Si la page n'est pas valide et ne contient que des données égales à 0, l'unité de contrôle n'a pas d'opération à réaliser dans cette page.

Si la page est valide, la page est lue au moyen du circuit PRCT2 et est copiée dans le tampon PBUFA (les données de page mises à jour étant, pendant ce temps, conservées dans le tampon PBUFB). Le champ d'adresse présent dans la page est appliqué au décodeur de ligne CDEC1 via le tampon PBUFA, le bus d'adresse et le multiplexeur MX3. Le contenu du tampon PBUFA est ensuite transféré dans le circuit PRCT1 et est écrit dans la page concernée de la zone MA. Le drapeau CS de la page est mis à 0 avant l'écriture des mots et le drapeau COK est mis à 0 après écriture des mots.

Etape 36 : Après son transfert dans la zone MA, la page du secteur CTM désignée par le pointeur PT est invalidée et son adresse physique est retirée de la table VAM. A cet effet le drapeau IS de la page est mis à 0, puis toutes les données de la page du secteur CTM sont mises à 0 (gestion des niveaux de charges électriques) sauf les drapeaux IOK et MER, qui sont mis à 0 en dernier lieu. Ici également cette mise à zéro est optionnelle et n'est prévue qu'en relation avec la gestion des niveaux de charges électriques.

Etape 38 : Cette étape vise à incrémenter le pointeur PT. L'unité de contrôle détermine préalablement si l'adresse XAD0 fournie par le compteur CPT1, qui représente les bits de poids faible LSB(PT) de l'adresse fournie par le pointeur, est égale à N-1, soit la valeur maximale du champ d'adresse dans chaque secteur. Si l'adresse maximale N-1 est atteinte l'unité de contrôle remet le compteur CPT1 à zéro sinon elle l'incrémente d'une unité au moyen du signal INCR. La valeur du compteur incrémentée reste une valeur interne du compteur et n'est pas déverrouillée par le tampon SH.

Etape 40 : Les données de page mises à jour, présentes dans le tampon PBUFB, sont transférées dans le tampon PBUFA. L'adresse de secteur SAD appliquée au pointeur est modifiée par l'unité de contrôle pour adresser le secteur CUR. Ainsi le pointeur PT fournit maintenant l'adresse d'une page effacée dans le secteur CUR (ayant la même adresse de poids faible que la page du secteur CTM objet des étapes 34 et 36). Par ailleurs l'adresse RAD de la page cible est de nouveau placée sur le bus ADB, via l'entrée/sortie IO3 du tampon PBUFA. Le contenu du tampon PBUFA est transféré dans le circuit PRCT2 puis est écrit dans la page sélectionnée. Comme précédemment le drapeau CS de la page est préalablement mis à 0 et le drapeau COK est mis à 0 après l'écriture de la page. Le drapeau MER est également mis à zéro si la page source dont les données ont été chargées dans le tampon de page (étape 30) appartient au secteur CTM ou au secteur ERM, puisque les pages du secteur CTM sont rattachées à des pages cible effacées et les pages du secteur ERM sont rattachées à des pages cible en cours d'effacement.

Etape 42 : La page source est de nouveau sélectionnée pour être invalidée, la sortie de la table VAM (adresse XAD1) étant appliquée au décodeur RDEC2 via le multiplexeur MX2. Le drapeau IS de la page est mis à 0, puis toutes les données de la page du secteur CTM sont mises à 0 (gestion des niveaux de charges électriques) sauf les drapeaux IOK et MER, qui sont mis à 0 en dernier lieu. Si la page source appartient au secteur ERM, seul le drapeau IS est mis à 0. En effet la page contient l'adresse d'une page du secteur MA en cours d'effacement. Cette adresse ne peut être effacée tant que l'étape d'effacement n'est pas terminée, car elle est nécessaire pour régénérer la table EAM après une coupure d'alimentation électrique. Si la page source n'est pas la page cible, l'adresse XAD de la page source est retirée de la table VAM (signal DEL). L'adresse de la nouvelle page source, fournie par le pointeur PT (adresse XAD1) est enregistrée dans la table VAM au moyen du signal LD1 appliqué au registre REG1.

Etape 44 : Au cours cette étape, les identifiants de secteurs SID sont modifiés par l'unité de contrôle pour faire tourner les secteurs, si le pointeur a été mis à 0 au cours de l'étape 38.

Après l'étape 44, l'unité de contrôle revient à l'état initial d'attente d'une nouvelle commande.

### E - Exemples de cycles d'écriture-effacement

Le procédé selon l'invention sera mieux compris à la lumière d'exemples de cycles d'écriture-effacement selon l'invention. On suppose dans chacun des exemples ci-après que la mémoire reçoit une commande d'écriture d'un mot W et que la zone cible n'est pas dans l'état effacé, de sorte que le cycle d'écriture-effacement est déclenché.

### Exemple 1

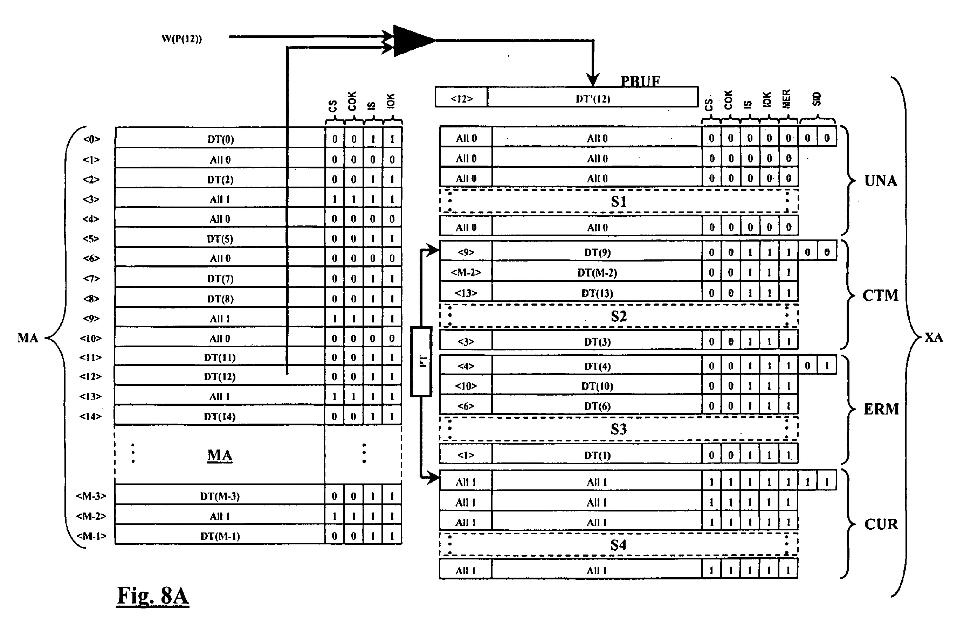

Les figures 8A à 8H illustrent le cas où la page source du cycle d'écriture-effacement est la page cible visée par commande d'écriture (ce qui signifie que la page source est dans la zone MA).

Figure 8A : La mémoire reçoit une commande d'écriture d'un mot W visant la page cible P(12). La page cible n'est pas invalide (IS=IOK=1) et est ainsi utilisée comme page source. Son contenu DT(12) est copié dans le tampon de page PBUF (PBUFA, PBUFB). Le nouveau mot W y est inséré pour obtenir des données de page mises à jour DT'(12).

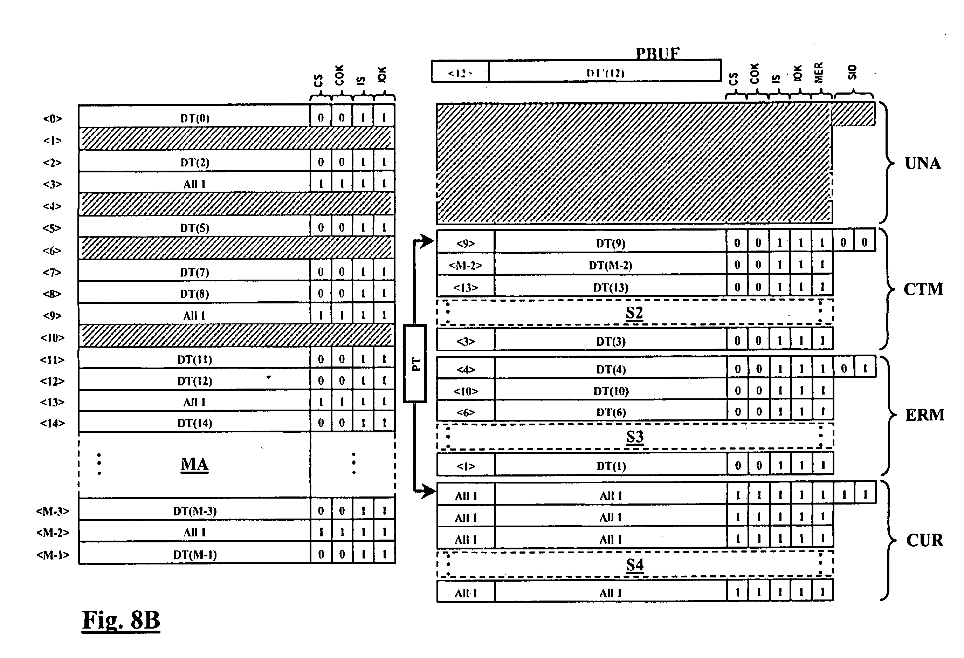

Figure 8B : une étape d'effacement partiel est appliquée aux pages du secteur UNA ainsi qu'à des pages de la zone MA dont les adresses <1>, <4>, <6>, <10> sont présentes dans les champs d'adresse de pages valides du secteur ERM dont le drapeau MER n'est pas égal à 0, et ont été précédemment copiées dans la table EAM. Il s'agit ici de la première étape d'effacement partiel après rotation des secteurs et le pointeur PT est positionné sur la première page du secteur CTM ou sur la première page du secteur CUR (selon l'adresse de secteur SAD qui lui est appliquée), ce qui signifie que l'adresse de poids faible XAD0 est égale à 0 dans le compteur CPT1 (fig. 6). Avant le commencement de l'étape d'effacement partiel, les pages d'adresses <1>, <4>, <6>, <10> contiennent des données qui sont toutes à 0 (All 0, fig. 8A) et des drapeaux qui sont également égaux à 0, car ces pages ont été précédemment invalidées. Ces données et drapeaux sont dans un état indéterminé "x" après l'étape d'effacement partiel, l'état indéterminé correspondant à une distribution de charges électriques dans les cellules mémoire qui ne correspond ni au "0" logique ni au "1" logique, le "1" logique ou valeur logique d'effacement ne pouvant être atteint qu'après N étapes d'effacement partiel.

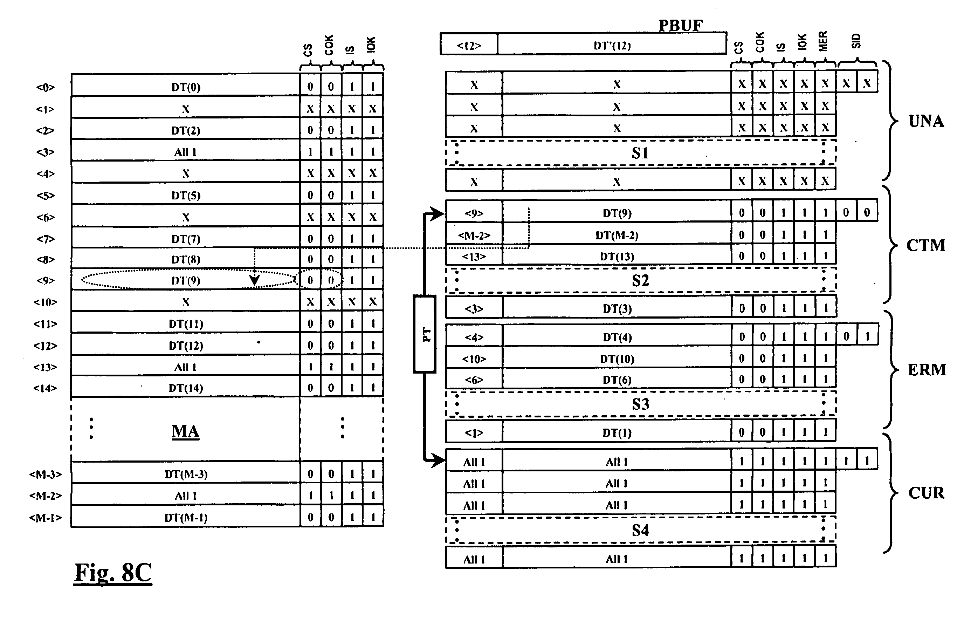

Figure 8C : l'adresse du secteur CTM (adresse de poids fort SAD) est appliquée au pointeur PT, le tampon de sortie SH (fig. 6) est déverrouillé et le pointeur désigne la première page du secteur CTM. La première page du secteur CTM est valide (IS = IOK = 1). Le champ d'adresse de cette page comprend l'adresse <9> (adresse virtuelle de la page). Les données de cette page sont donc transférées dans la page d'adresse physique <9> de la zone MA. L'étape de copie comprend la mise à 0 préalable du drapeau CS de la page d'adresse physique <9>, puis la copie des mots de la page d'adresse virtuelle <9> dans la page d'adresse physique <9>, puis la mise à 0 du drapeau COK de la page d'adresse physique <9>.

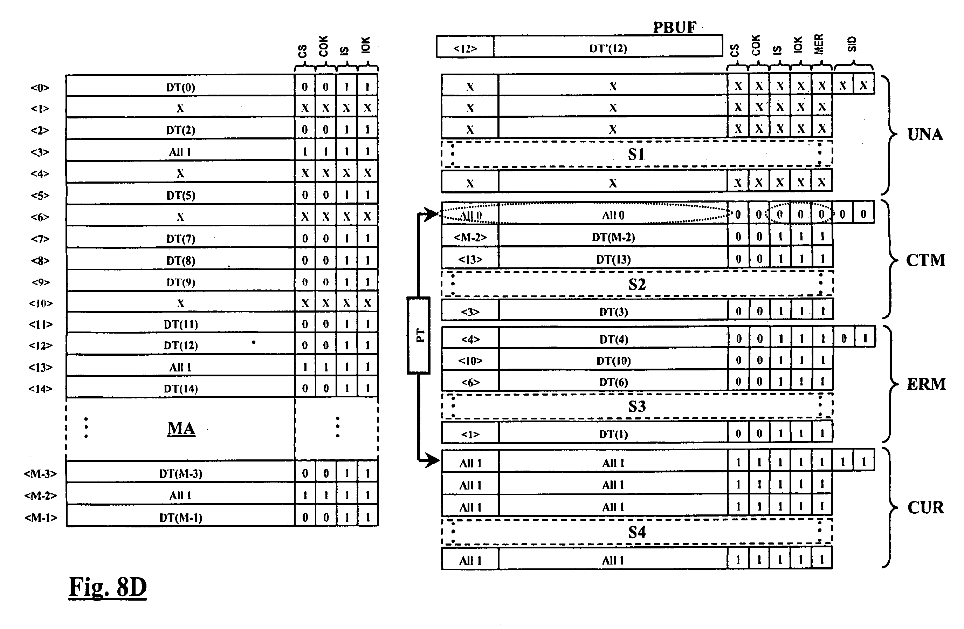

Figure 8D : la page d'adresse virtuelle <9> du secteur CTM est invalidée en mettant successivement à 0 le drapeau IS, puis les champs de donnée et d'adresse de la page, puis les drapeaux IOK et MER. L'adresse physique de cette page est retirée de la table VAM.

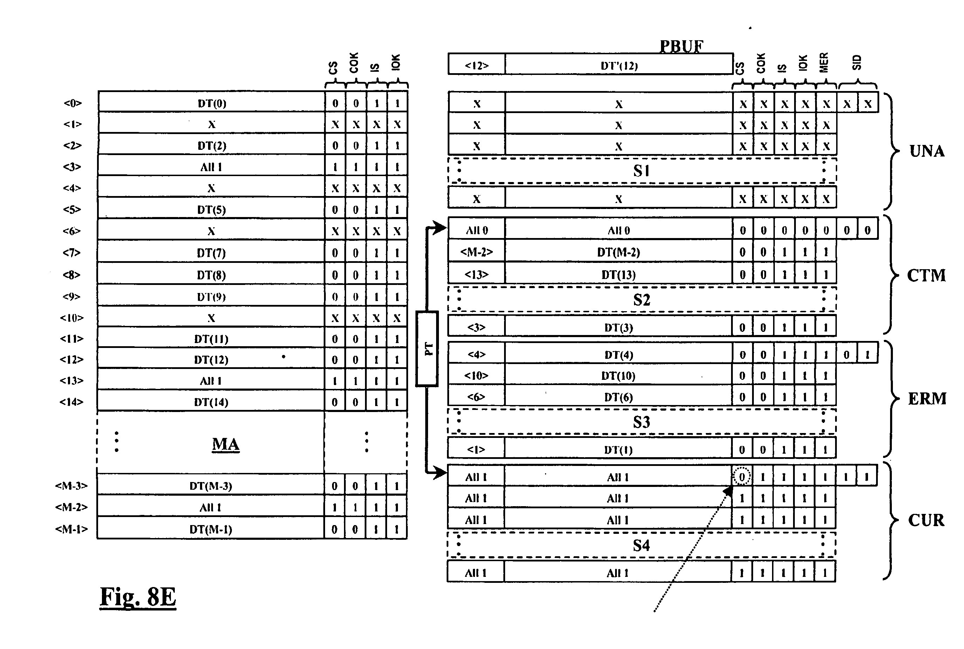

Figure 8E : L'unité de contrôle applique au pointeur PT l'adresse du secteur CUR, le tampon de sortie SH est déverrouillé et le pointeur désigne maintenant la page effacée du secteur CUR devant recevoir les données de page mises à jour, ici la première page du secteur CUR. Le drapeau CS de la page est mis à 0.

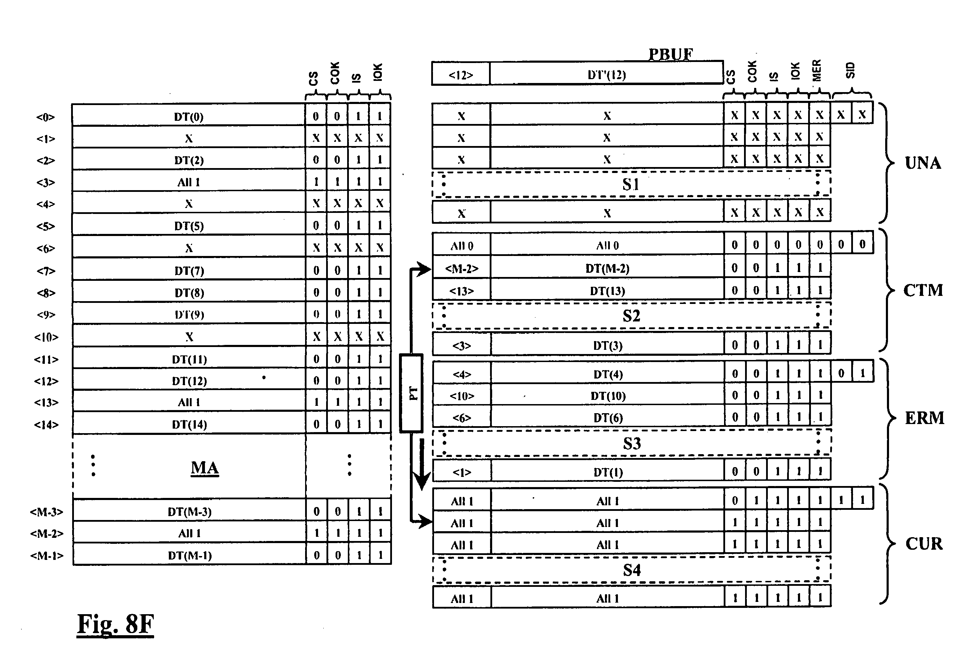

Figure 8F : le pointeur PT est incrémenté en appliquant le signal INCR au compteur CPT1 (fig. 6) mais la nouvelle adresse de pointeur reste bloquée par le tampon SH. Le pointeur est donc positionné sur l'adresse suivante mais cette adresse n'est pas validée à l'entrée du décodeur RDEC2 et du registre REG1 de la table VAM.

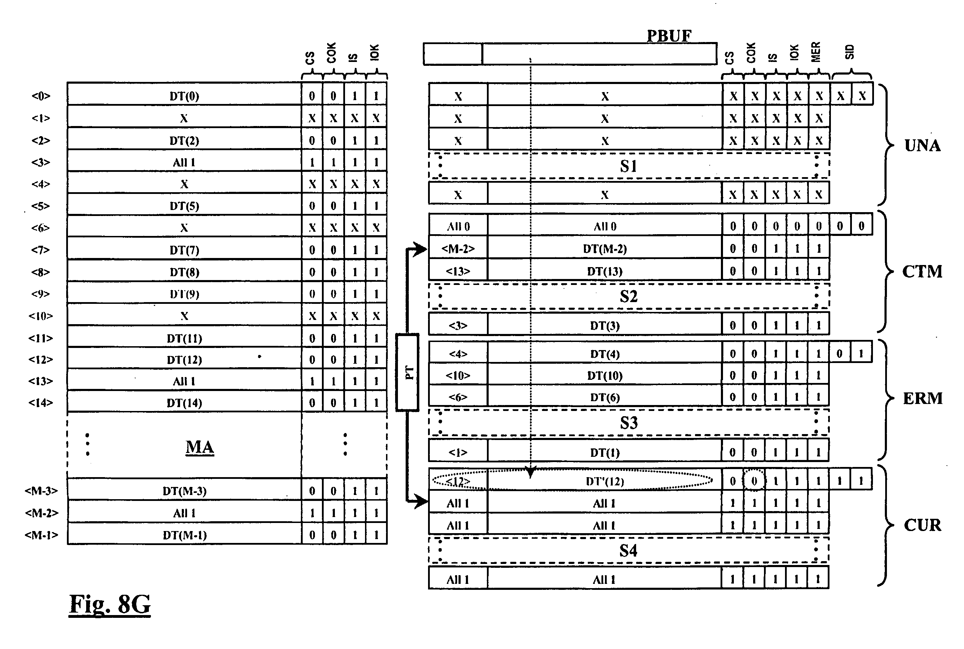

Figure 8G : les données de page mises à jour DT'(12) présentes dans le tampon PBUF, ainsi que l'adresse <12> de la page cible, sont écrites dans la page effacée du secteur CUR (le pointeur continuant à fournir l'adresse de cette page). L'écriture est effectuée dans l'ordre suivant : écriture des données et du champ d'adresse <12> puis mise à 0 du drapeau COK. Cette page devient donc une page source d'adresse virtuelle <12> mais ne sera enregistrée dans la table VAM qu'après invalidation de la page source.

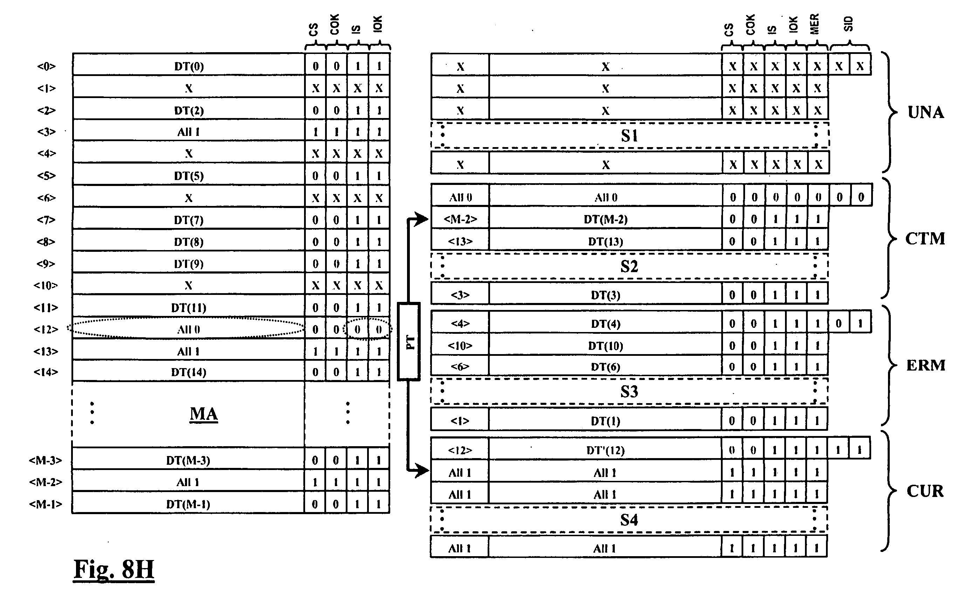

Figure 8H : la page source d'adresse <12> qui est également ici la page cible, est invalidée : mise à 0 le bit IS, mise à 0 de toutes les données de page, mise à 0 du bit IOK. L'adresse physique de la page d'adresse virtuelle <12>, fournie par le pointeur PT, est ensuite enregistrée dans la table VAM.

### Exemple 2

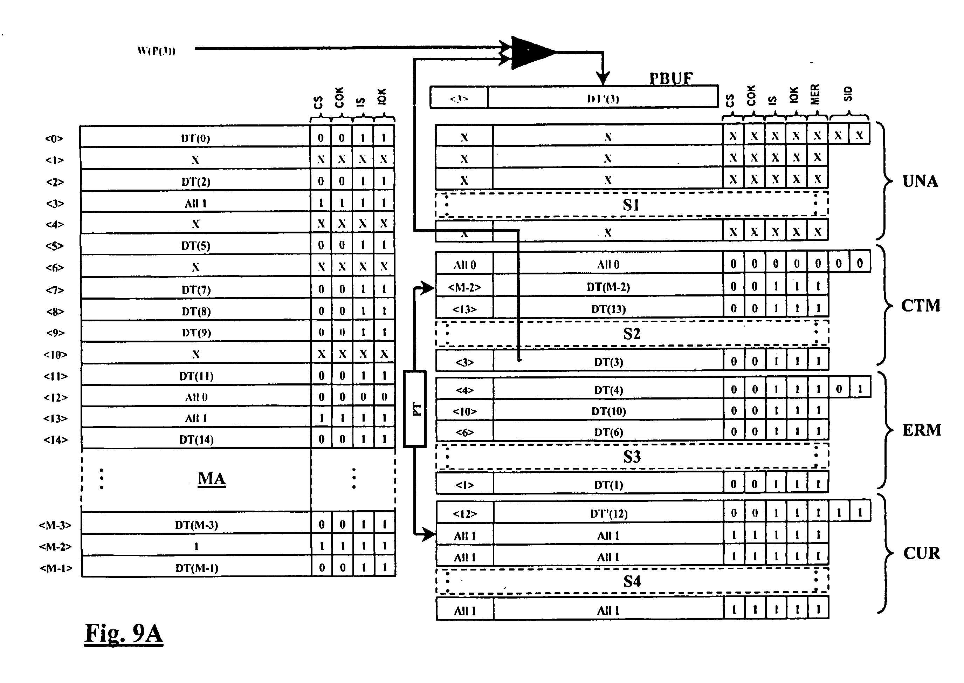

Les figures 9A à 9H illustrent le cycle d'écriture-effacement dans le cas où la page source est dans le secteur CTM, ce qui signifie que les données de la page cible correspondante ont déjà été transférées dans la page source au cours d'une mise à jour précédente.

Figure 9A : La mémoire reçoit une commande d'écriture d'un mot W visant la page cible P(3). La page cible est dans l'état effacé ("All 1", tous ses bits sont à 1) et la table VAM désigne une page source dans le secteur CTM d'adresse virtuelle <3>. Le contenu DT(3) de la page source est copié dans le tampon de page PBUF. Le nouveau mot W y est inséré pour obtenir des données de page mises à jour DT'(3).

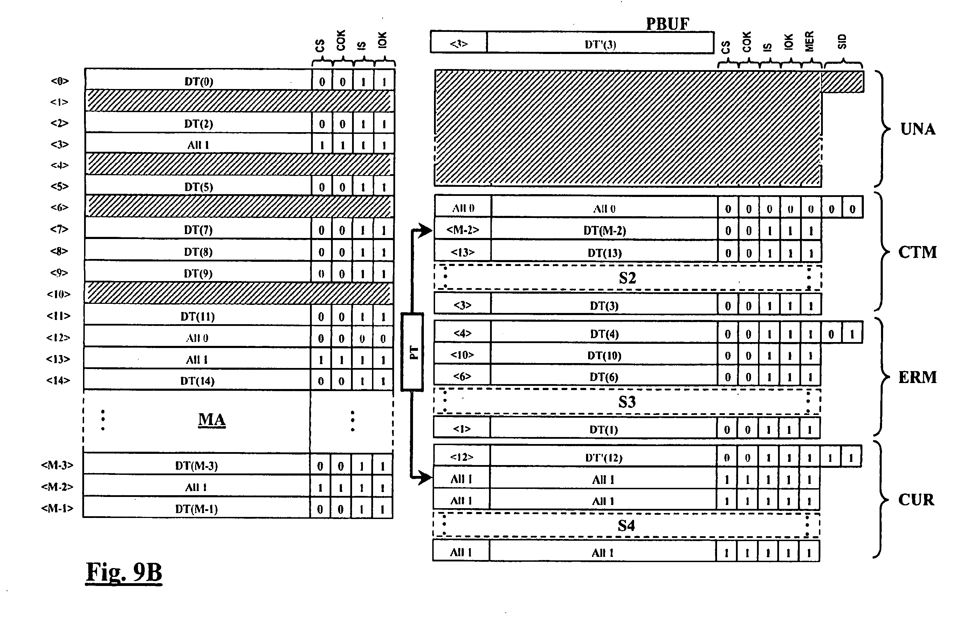

Figure 9B : une nouvelle étape d'effacement partiel est appliquée aux pages du secteur UNA et aux pages de la zone MA d'adresses <1>, <4>, <6>, <10>. Il s'agit ici de la seconde étape d'effacement partiel et le pointeur PT est positionné sur la seconde page du secteur CTM ou sur la seconde page du secteur CUR (selon l'adresse de secteur SAD qui lui est appliquée). Après cette étape d'effacement partiel, les pages d'adresses <1>, <4>, <6>, <10> contiennent toujours des données qui sont dans un état indéterminé "x".

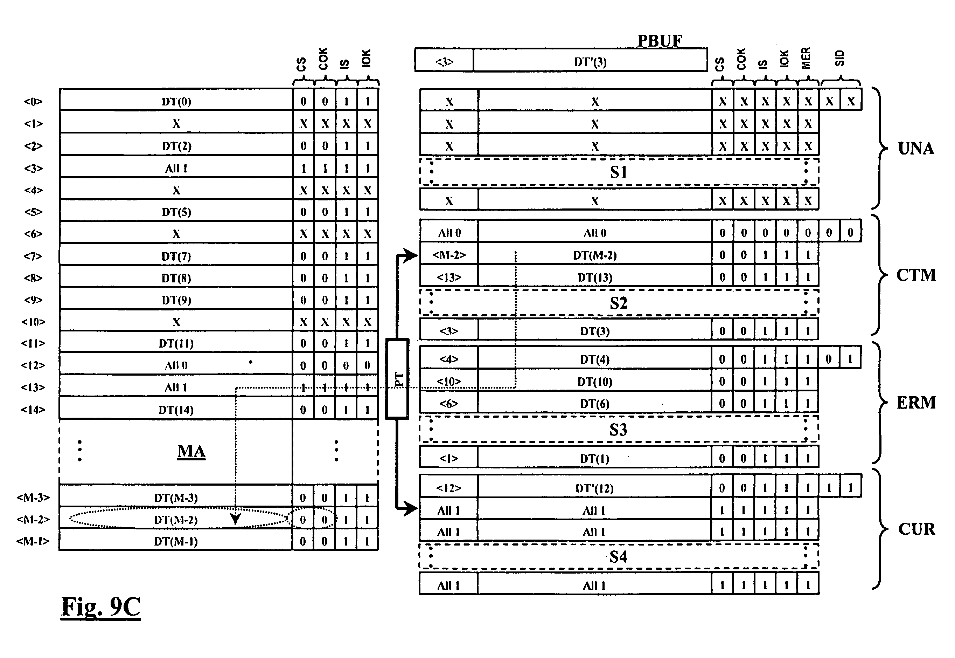

Figure 9C : l'adresse du secteur CTM est appliquée au pointeur PT, le tampon de sortie SH est déverrouillé et le pointeur désigne la seconde page du secteur CTM. Cette page est valide (IS, IOK = 1) et son champ d'adresse comprend l'adresse <M-2> (adresse virtuelle de la page). Les données de cette page sont donc transférées dans la page d'adresse physique <M-2> de la zone MA et les drapeaux CS et COK de cette dernière sont mis à zéro.

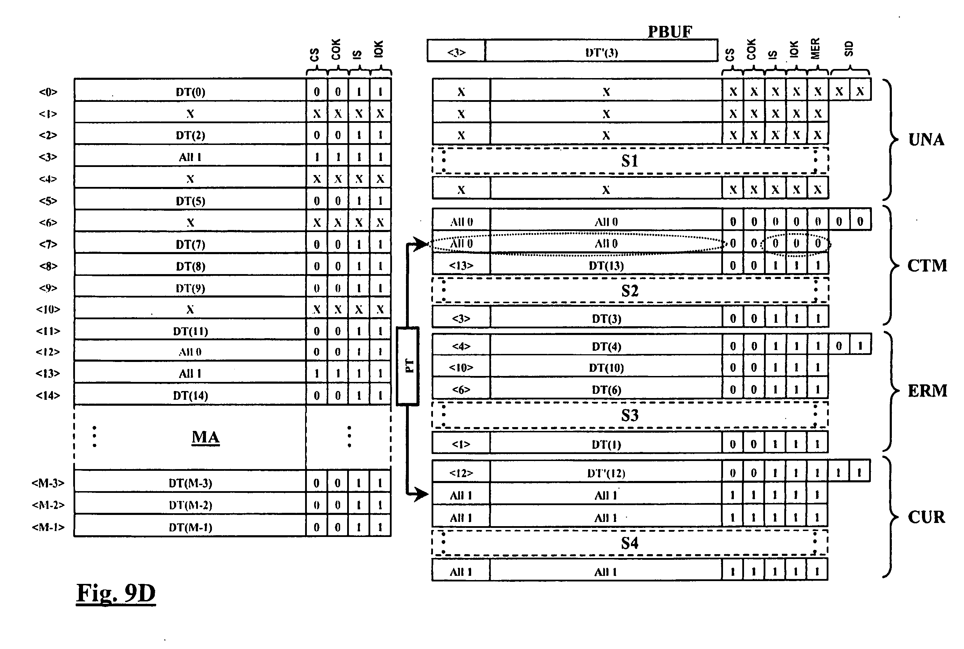

Figure 9D : la page d'adresse virtuelle <M-2> du secteur CTM est invalidée en mettant successivement à 0 le drapeau IS, puis les champs de donnée et d'adresse de la page, puis les drapeaux IOK et MER. L'adresse physique de cette page est retirée de la table VAM.

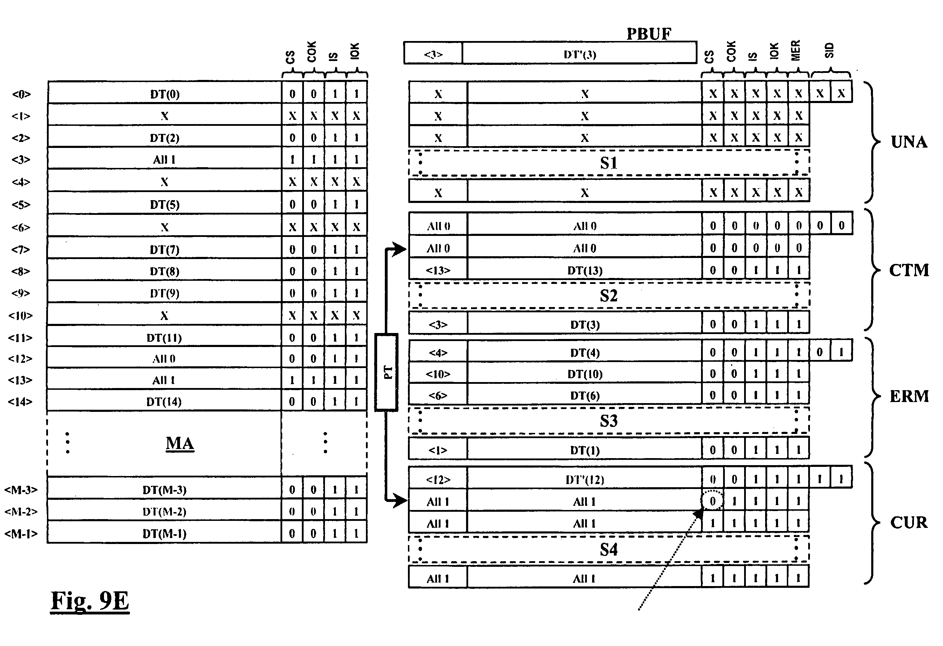

Figure 9E : L'unité de contrôle applique au pointeur PT l'adresse du secteur CUR, le tampon de sortie SH est déverrouillé et le pointeur désigne maintenant la page effacée du secteur CUR devant recevoir les données de page mises à jour, ici la seconde page du secteur CUR. Le drapeau CS de la page est mis à 0.

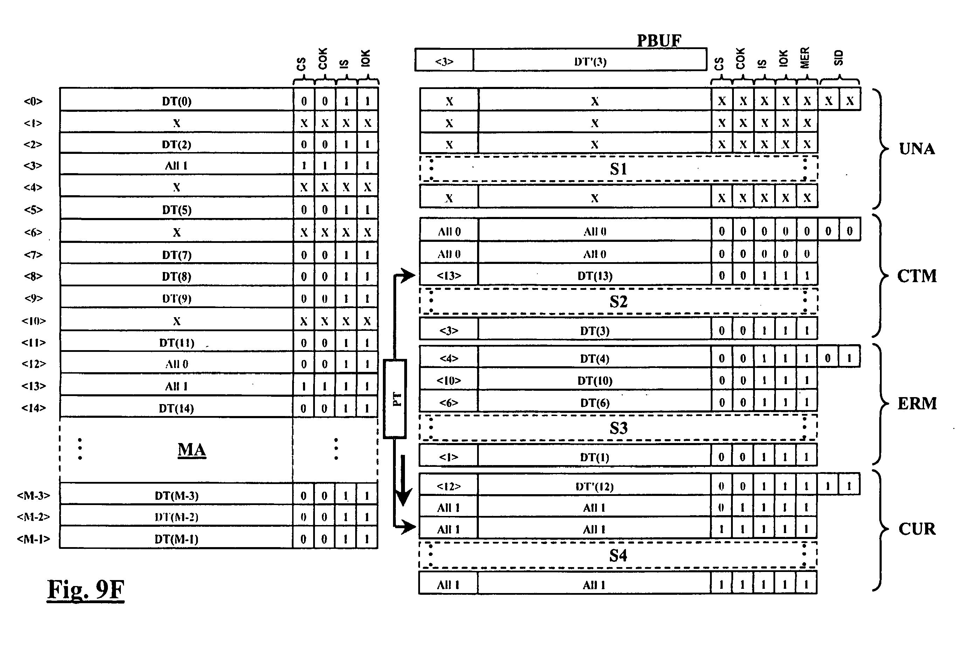

Figure 9F : le pointeur PT est incrémenté en appliquant le signal INCR au compteur CPT1 (fig. 6) mais le tampon SH n'est pas déverrouillé.

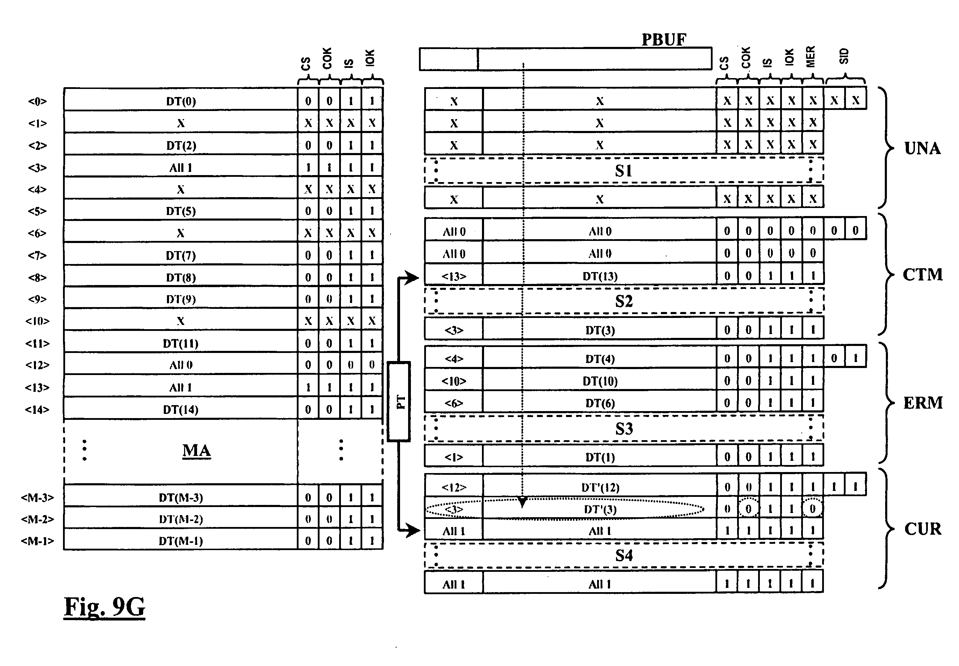

Figure 9G : les données de page mises à jour DT'(3) présentes dans le tampon PBUF, ainsi que l'adresse <3> de la page cible, sont écrites dans la page effacée du secteur CUR. Le drapeau COK est mis à 0. Le drapeau MER est également mis à 0 car la page source appartient au secteur CTM et est ainsi rattachée à une page effacée de la zone MA. La page d'arrivée dans le secteur CUR devient ainsi une page d'adresse virtuelle <3> mais ne sera enregistrée dans la table VAM qu'après invalidation de la page source.

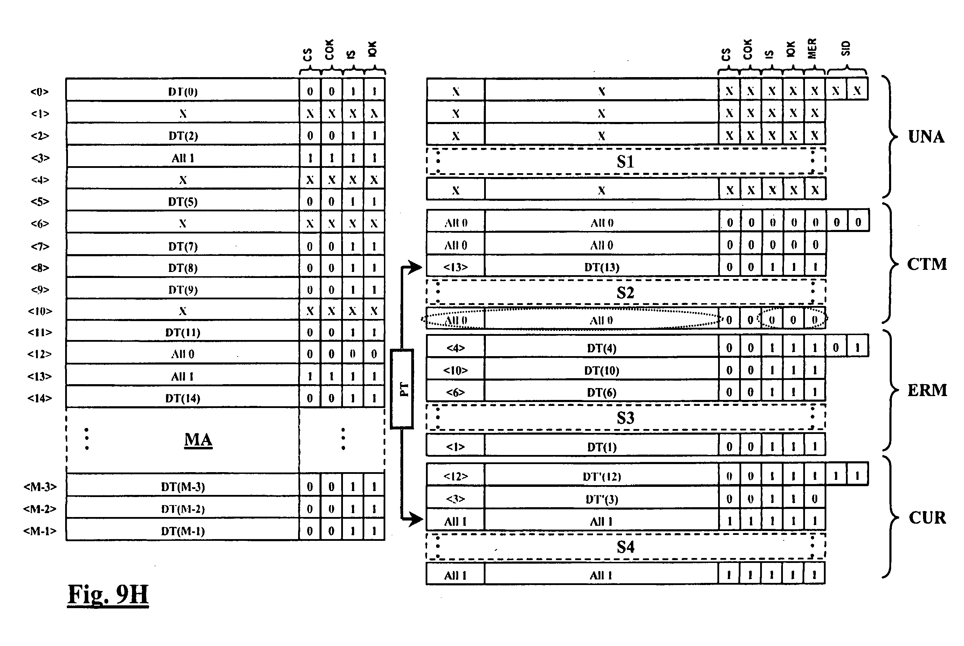

Figure 9H : la page source d'adresse virtuelle <3>, dont l'adresse physique est fournie par la table VAM, est invalidée : mise à 0 du bit IS, mise à 0 de toutes les données de page, mise à 0 du bit IOK. Son adresse physique est ensuite retirée de la table VAM. L'adresse physique de la nouvelle page d'adresse virtuelle <3>, fournie par le pointeur PT, est enregistrée dans la table VAM. A noter que le passage d'une page à l'autre pour les opérations qui viennent d'être décrites est effectué à l'aide du multiplexeur MX2 (fig. 6) qui permet de passer alternativement d'une adresse de page auxiliaire fournie par la table VAM à une adresse de page auxiliaire fournie par le pointeur PT.

### Exemple 3

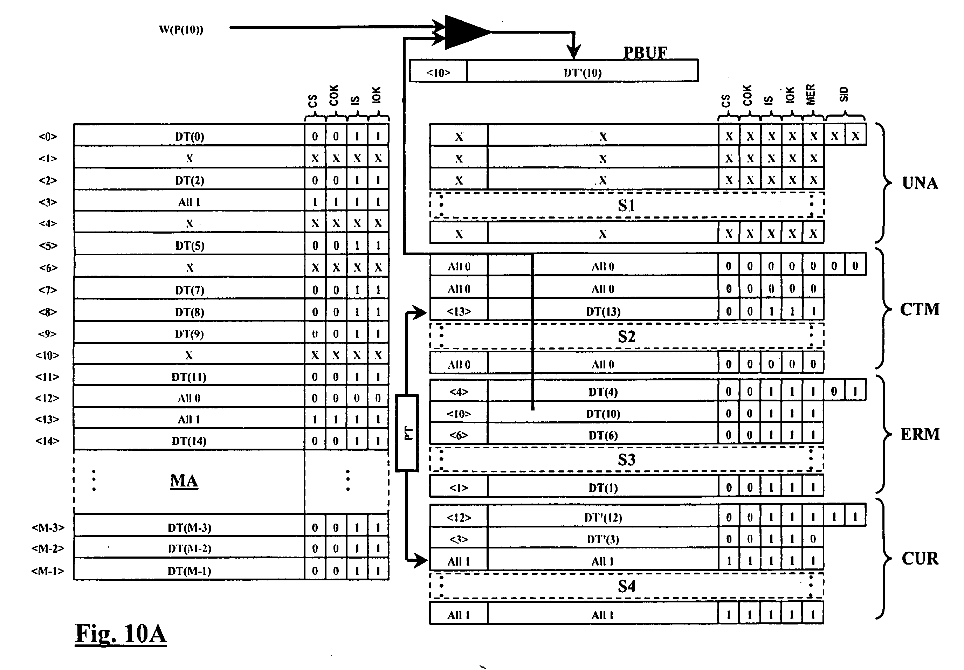

Les figures 10A à 10C illustrent le cycle d'écriture-effacement dans le cas où la page source est dans le secteur ERM.

Figure 10A : La mémoire reçoit une commande d'écriture d'un mot W visant la page cible P(10). La page cible est en cours d'effacement (tous ses bits sont à la valeur indéterminée "x") et la table VAM désigne la page source d'adresse virtuelle <10> dans le secteur ERM. Le contenu DT(10) de la page source est copié dans le tampon de page PBUF. Le nouveau mot W y est inséré pour obtenir des données de page mises à jour DT' (10).

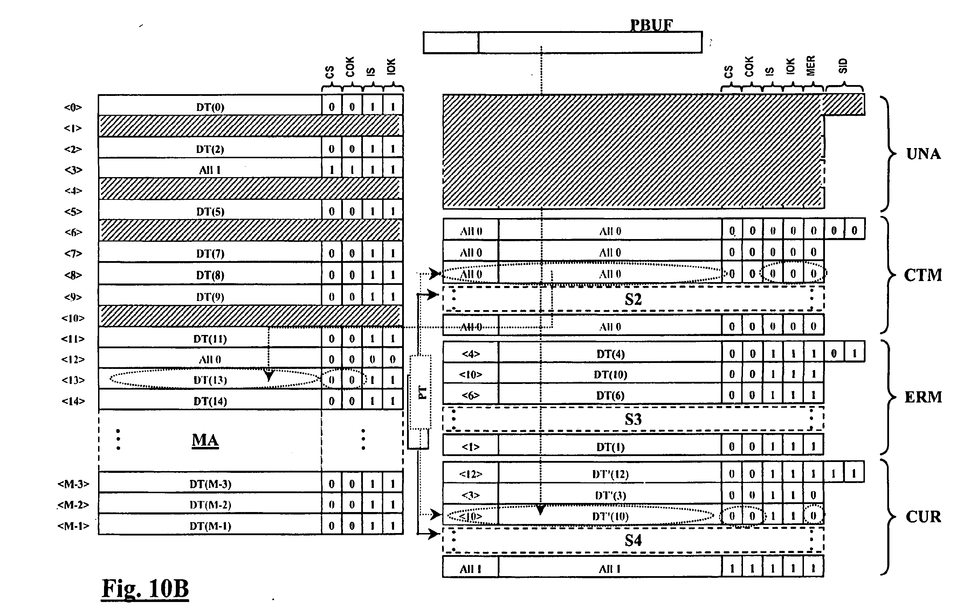

Figure 10B : plusieurs étapes sont représentées regroupées sur cette figure. Une nouvelle étape d'effacement partiel est appliquée aux pages du secteur UNA et aux pages de la zone MA d'adresses <1>, <4>, <6>, <10>. L'adresse du secteur CTM est ensuite appliquée au pointeur PT, le tampon de sortie SH est déverrouillé et le pointeur désigne la troisième page du secteur CTM. La troisième page du secteur CTM est valide (IS, IOK = 1). Le champ d'adresse de cette page comprend l'adresse <13>. Les données de cette page sont donc transférées dans la page d'adresse physique <13> de la zone MA. Les drapeaux CS et COK de cette page sont mis à zéro. La page d'adresse virtuelle <13> du secteur CTM est ensuite invalidée en mettant successivement à 0 le drapeau IS, puis les champs de donnée et d'adresse de la page, puis les drapeaux IOK et MER. L'adresse physique de cette page est retirée de la table VAM. L'unité de contrôle applique ensuite au pointeur PT l'adresse du secteur CUR, le tampon de sortie SH est déverrouillé et le pointeur désigne la page effacée du secteur CUR devant recevoir les données de page mises à jour, ici la troisième page du secteur CUR. Le drapeau CS de la page est mis à 0. La valeur interne du pointeur PT est incrémentée. Les données de page mises à jour DT'(10) dans le tampon PBUF, ainsi que l'adresse <10> de la page cible, sont écrites dans la page effacée du secteur CUR. Le drapeau COK est mis à 0. Le drapeau MER est également mis à 0 ici, car la page source d'adresse virtuelle <10> est dans le secteur ERM et la page correspondante d'adresse physique <10> est en cours d'effacement. Le drapeau MER indique ainsi qu'il ne sera pas nécessaire d'effacer la page correspondante dans la zone MA lorsque le secteur CUR aura le statut de secteur ERM (après l'étape de rotation des secteurs).

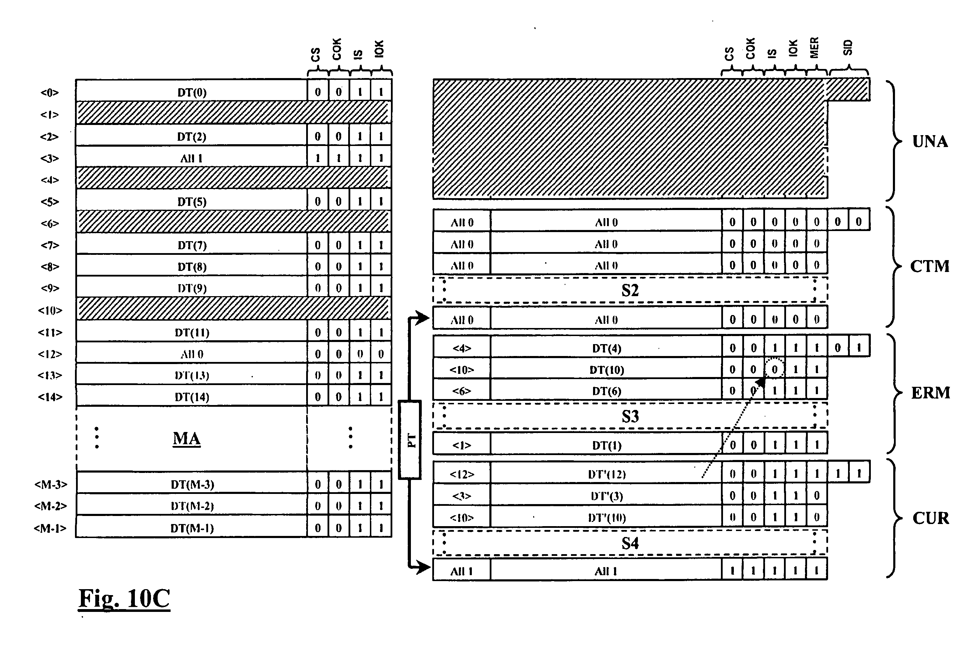

Figure 10C : la page source d'adresse virtuelle <10> est invalidée en mettant à 0 du bit IS. Toutefois le reste de la page n'est pas mis à 0 car cette page appartient au secteur ERM et son champ d'adresse peut être nécessaire pour régénérer la table EAM en cas de coupure d'alimentation électrique. Son adresse physique est toutefois retirée de la table VAM. L'adresse de la nouvelle page d'adresse virtuelle <10> est enregistrée dans la table VAM.

### Exemple 4

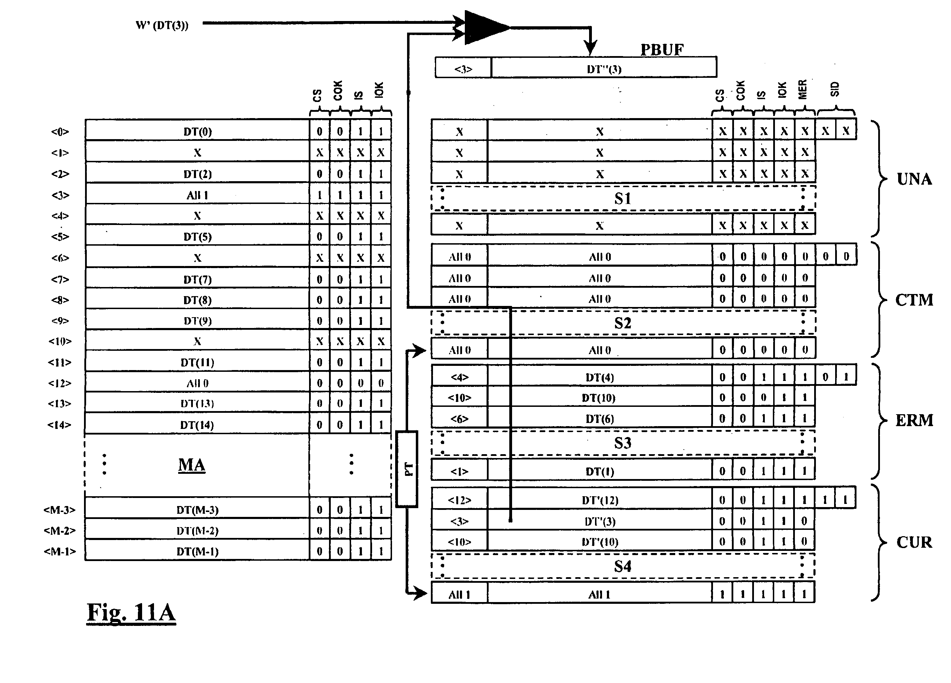

Les figures 11A à 11F illustrent le cycle d'écriture-effacement dans le cas où la page source est dans le secteur CUR.

Figure 11A : La mémoire reçoit une commande d'écriture d'un mot W visant la page cible P(3). La page cible est dans l'état effacé et la table VAM désigne une page d'adresse virtuelle <3> dans le secteur CUR qui est ainsi utilisée comme page source. Cette page a été mise à jour récemment (fig. 9G). Son contenu DT'(3) est copié dans le tampon de page PBUF. Le nouveau mot W y est inséré pour obtenir des données de page mises à jour DT'' (3).

### Figure 11B :

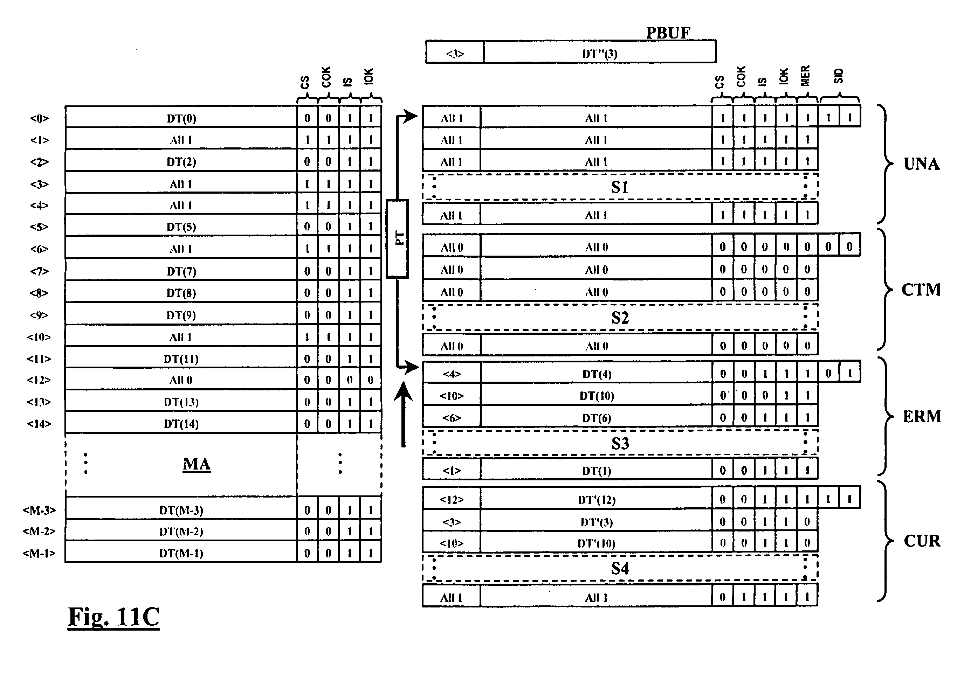

i) une étape d'effacement partiel est appliquée aux pages du secteur UNA et aux pages de la zone MA d'adresses <1>, <4>, <6>, <10>. Il s'agit ici de la dernière étape d'effacement partiel avant rotation des secteurs et le pointeur PT est positionné sur la dernière page du secteur CTM ou sur la dernière page du secteur CUR (selon l'adresse de secteur SAD qui lui est appliquée). Après cette dernière étape, les pages d'adresses <1>, <4>, <6>, <10> sont entièrement effacées et ne contiennent que des données à 1 ("All 1", Cf. fig. 11C).
ii) L'adresse du secteur CTM est ensuite appliquée au pointeur PT, le tampon de sortie SH est déverrouillé et le pointeur désigne la dernière page du secteur CTM. Cette dernière page du secteur CTM ne contient que des 0 ("All 0") car elle a été récemment invalidée (Cf. fig. 9H). Par conséquent elle n'est pas transférée dans la zone MA.
iii) L'unité de contrôle applique ensuite au pointeur PT l'adresse du secteur CUR, le tampon de sortie SH est déverrouillé et le pointeur désigne maintenant une page effacée du secteur CUR devant recevoir les données de page mises à jour, ici la dernière page du secteur CUR. Le drapeau CS de la page est mis à 0.

Figure 11C : le pointeur PT est remis à zéro (remise à zéro de son adresse de poids faible en appliquant le signal RST au compteur CPT1, fig. 6) car le test "LSB(PT) = N-1" est positif (Cf. fig. 7B étape 38). En d'autres termes, le pointeur est remis à 0 car son adresse de poids faible LSB, fournie par le compteur CPT1, a atteint la valeur maximale du champ d'adresse des secteurs.

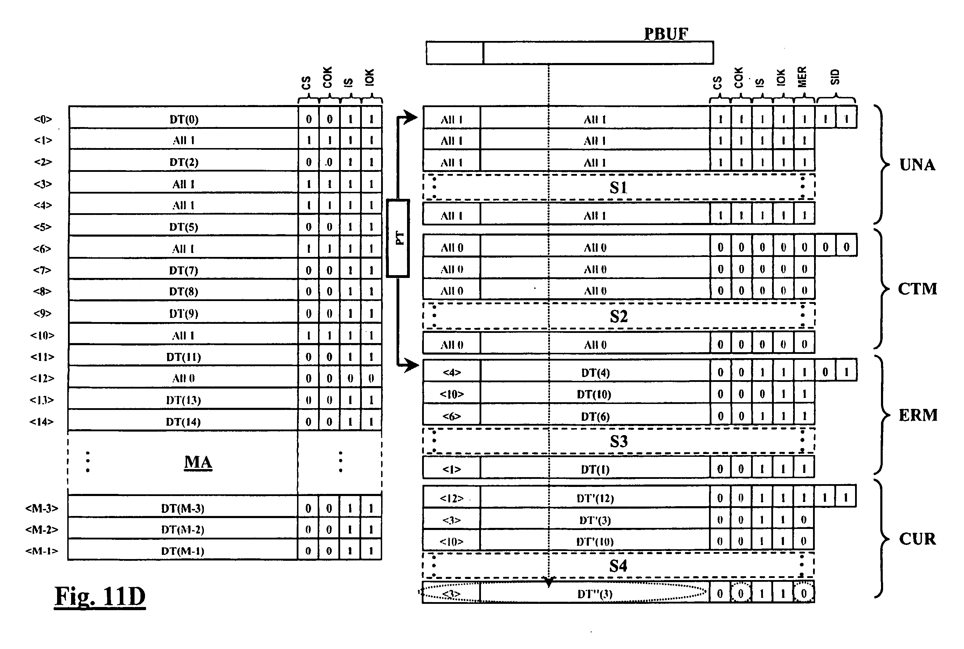

Figure 11D : les données de page mises à jour DT''(3) présentes dans le tampon PBUF, ainsi que l'adresse <3> de la page cible, sont écrites dans la page effacée du secteur CUR (le pointeur continuant à fournir l'adresse physique de cette page tant que le tampon SH n'est pas déverrouillé). Le drapeau COK est mis à 0. Le drapeau MER est également mis à 0 car le drapeau MER de la page source est égal à 0. On voit en effet que la page correspondante dans la zone MA, d'adresse physique <3> est maintenant effacée.

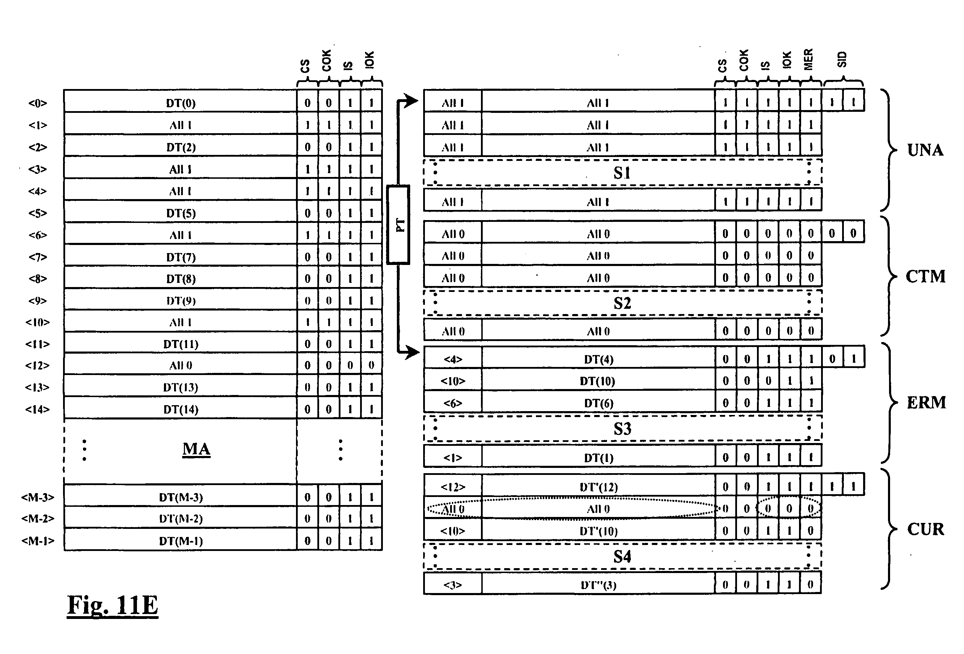

Figure 11E : la page source d'adresse virtuelle <3> est invalidée : mise à 0 du bit IS, mise à 0 de toutes les données de page, mise à 0 du bit IOK. Son adresse physique est retirée de la table VAM. L'adresse physique de la nouvelle page d'adresse virtuelle <3>, fournie par le pointeur PT, est enregistrée dans la table VAM.

Figure 11F : la rotation des secteurs est effectuée en modifiant les champs SID des secteurs S3 et S4. Le second bit du champ SID du secteur S3 est mis à 0 et le premier bit du champ SID du secteur S4 est mis à 0. Les secteurs S1, S2, S3 et S4 deviennent respectivement secteurs CUR, UNA, CTM et ERM.

### F - Variantes de réalisation et applications

On a décrit dans ce qui précède un mode de réalisation d'une mémoire selon l'invention qui rassemble tous les aspects de l'invention, notamment :
- l'écriture de données dans des pages auxiliaires non volatiles comprenant un champ d'adresse recevant l'adresse de la page cible correspondante, ceci permettant notamment d'utiliser une table de correspondance volatile et de régénérer la table de correspondance après une coupure d'alimentation électrique,
- l'écriture de données dans des pages effacées, pour diminuer le temps apparent d'effacement et/ou limiter les conséquences d'une coupure d'alimentation électrique,
- la prévision d'une étape d'effacement partiel, à chaque écriture d'une donnée, pour diminuer le temps apparent d'effacement et/ou éviter d'interrompre la réception d'un flot d'instructions,
- la prévision de drapeaux d'état non volatiles (IS, IOK) pour l'invalidation de pages,
- la prévision d'une redondance de ces drapeaux pour limiter les conséquences d'une coupure d'alimentation électrique,
- la prévision de drapeaux d'état non volatiles (CS, COK) pour marquer les étapes d'écriture et limiter les conséquences d'une coupure d'alimentation électrique,
- la prévision d'une mémoire auxiliaire agencée en quatre secteurs permettant de mettre en oeuvre un cycle d'écriture-effacement comprenant une étape de vidage de la mémoire auxiliaire, etc.

Comme cela a déjà été souligné, ces aspects de l'invention peuvent être mis en oeuvre les uns indépendamment des autres, en fonction des objectifs recherchés et des applications visées. Par exemple, les aspects de l'invention se rapportant à la protection contre l'arrachement (redondance des drapeaux IS, IOK et prévision des drapeaux CS, COK) ne sont pas nécessaires dans une application où le risque de coupure d'alimentation électrique intempestif n'existe pas. De même, les aspects de l'invention relatifs à la prévision des quatre secteurs de la zone auxiliaire XA sont avantageux pour assurer la réception d'un flot ininterrompu d'instructions mais la zone XA pourrait aussi ne comporter que deux secteurs CUR, CTM. Dans ce cas l'effacement du secteur CTM et des pages de la zone MA rattachées aux pages du secteur CUR serait assuré au cours d'une étape de repos suivant la réception de N commandes d'écriture, le secteur CTM devenant ensuite secteur CUR et le secteur CUR devenant secteur CTM. Egalement, les champs d'adresse dans les pages auxiliaires ne seraient pas nécessaires si une table VAM non volatile était utilisée. Egalement, l'ordre des étapes du cycle d'écriture-effacement décrit plus haut est susceptible de modification, par exemple en effectuant le transfert des pages du secteur CTM avant l'étape d'effacement partiel, ou l'étape d'effacement partiel après l'écriture des données de page mises à jour dans la page d'arrivée, etc.. De façon générale, il est à la portée de l'homme de l'art de concevoir diverses variantes et modes de réalisation mettant en oeuvre tout ou partie des aspects de l'invention.

Dans la description qui précède, l'invention a été mise en oeuvre dans une mémoire de type page-FLASH, c'est-à-dire une mémoire divisée en pages dans laquelle les pages sont effaçables individuellement ou par groupes de pages sélectionnées individuellement, et dans laquelle chaque page est divisée en segments inscriptibles individuellement prévus pour recevoir chacun un mot binaire. Il apparaîtra clairement à l'homme de l'art que cet exemple de réalisation n'est pas limitatif et que le procédé selon l'invention peut être mis en oeuvre, par exemple, dans une mémoire où les données s'écrivent par page au lieu de s'écrire par mot (cas où la granularité en écriture est choisie égale à la granularité en effacement). Dans ce cas, l'étape de test de la zone cible n'a plus de raison d'être ni l'étape de préparation des données de page mises à jour, puisque les données de chaque nouvelle page doivent écraser toutes les données de page précédemment enregistrées.

Également, le terme "page" ne doit pas être limitativement interprété comme désignant un ensemble de cellules mémoire connectées à une même ligne de mot contrôlée par un décodeur de ligne. Le terme "page" désigne de façon générale un emplacement qui est effaçable individuellement et comprend une pluralité de cellules mémoire. Cet emplacement peut être divisé ou non en segments inscriptibles individuellement. Également, le mot "secteur" tel qu'utilisé pour désigner des subdivisions de la zone mémoire XA ne désigne pas nécessairement des secteurs physiques (substrats distincts) mais peut désigner des secteurs logiques, voire des parties d'un plan mémoire global incluant les zones MA et XA. Par ailleurs, chaque aspect de l'invention précédemment décrit constitue en soi un perfectionnement susceptible d'application sans nécessairement être combiné avec les autres aspects de l'invention. L'invention permet la réalisation de mémoires enchâssées (embedded memories) et notamment de mémoires enchâssées dans des circuits intégrés pour cartes à puce ou étiquettes électroniques. L'invention permet notamment d'utiliser les mémoires Flash comme mémoires enchâssées, application qui était jusqu'à présent réservée aux mémoires EEPROM. L'invention inclut ainsi la réalisation d'une carte à puce ou d'une étiquette électronique (du type à contact ou sans contact RFID ou UHF) comprenant un circuit intégré équipé d'une mémoire selon l'invention.

## Revendications

1. Procédé d'écriture de données dans une mémoire non volatile comportant des cellules mémoire devant être effacées avant d'être écrites, comprenant les étapes consistant à prévoir dans la mémoire :
- une zone mémoire principale (MA) non volatile comprenant des pages cible, et
- une zone mémoire auxiliaire (XA) non volatile comprenant des pages auxiliaires effacées utilisables pour écrire des données, des pages auxiliaires contenant des données rattachées à des pages cible à effacer ou en cours d'effacement, des pages auxiliaires contenant des données à transférer dans des pages cible effacées, et des pages auxiliaires à effacer ou en cours d'effacement,
**caractérisé en ce qu'**il comprend les étapes consistant à prévoir, dans la zone mémoire auxiliaire :
- un secteur courant (CUR) comprenant des pages auxiliaires effacées utilisables pour écrire des données,
- un secteur de sauvegarde (ERM) distinct du secteur courant, comprenant des pages auxiliaires contenant des données rattachées à des pages cible à effacer ou en cours d'effacement,
- un secteur de transfert (CTM) distinct du secteur courant et du secteur de sauvegarde, comprenant des pages auxiliaires contenant des données à transférer dans des pages cible effacées, et
- un secteur indisponible (UNA) distinct du secteur courant, du secteur de sauvegarde et du secteur de transfert, comprenant des pages auxiliaires à effacer ou en cours d'effacement.

2. Procédé selon la revendication 1 comprenant, en réponse à une commande d'écriture d'une donnée dans une page cible, les étapes consistant à :
- appliquer (32) une étape d'effacement partiel aux pages auxiliaires du secteur indisponible (UNA) et à des pages cible (XA) rattachées à des pages du secteur de sauvegarde (CTM),
- transférer (34) des données d'une page auxiliaire du secteur de transfert (CTM) vers une page effacée de la zone mémoire principale (MA), si la page auxiliaire est valide, et invalider (36) la page auxiliaire, et
- écrire (40) la donnée dans une page auxiliaire effacée du secteur courant, et invalider la page cible (42).

3. Procédé selon la revendication 2 comprenant, en réponse à une commande d'écriture d'une donnée dans une page cible, les étapes consistant à :
- écrire (40) la donnée dans une seconde page auxiliaire effacée, si une donnée précédente de même adresse de page cible a déjà été écrite dans une première page auxiliaire, et
- invalider (42) la première page auxiliaire.

4. Procédé selon l'une des revendications 2 et 3, comprenant les étapes consistant à :
- prévoir un champ d'adresse (AF) dans les pages auxiliaire, et
- lorsqu'une donnée est écrite dans une page auxiliaire, écrire dans le champ d'adresse de la page auxiliaire l'adresse de page cible de la donnée.

5. Procédé selon l'une des revendications 2 à 4 comprenant, en réponse à une commande d'écriture d'une donnée dans une page cible, l'étape (22) consistant à écrire directement la donnée dans la page cible ou dans une page auxiliaire valide contenant une donnée précédemment écrite ayant la même adresse de page cible, si des cellules mémoire devant recevoir la donnée sont effacées dans la page cible ou dans la page auxiliaire.

6. Procédé selon l'une des revendications 2 à 5, comprenant les étapes consistant à :
- avant d'écrire une donnée dans une page auxiliaire, lire (30) un ensemble initial de données dans une page source,
- insérer (30) la donnée à écrire dans l'ensemble initial de données, pour obtenir un ensemble de données mis à jour, puis
- écrire (40) l'ensemble de données mis à jour dans la page auxiliaire.

7. Procédé selon l'une des revendications 1 à 6, comprenant les étapes consistant à :
- tenir à jour une table de correspondance (VAM) entre des adresses de pages cible invalides et des adresses de pages auxiliaires valides, et
- lorsqu'une donnée doit être lue dans une page cible, lire la donnée dans une page auxiliaire valide si l'adresse de la page auxiliaire valide existe dans la table de correspondance, sinon lire la donnée dans la page cible.

8. Procédé selon l'une des revendications 1 à 7, comprenant une étape consistant à utiliser un pointeur (PT) de page auxiliaire pour désigner à la fois dans le secteur de transfert (CTM) une page auxiliaire dont le contenu doit être transféré dans une page cible et dans le secteur courant (CUR) une page effacée à utiliser pour écrire une donnée.

9. Procédé selon l'une des revendications 1 à 8, comprenant l'étape consistant à appliquer au secteur à effacer (UNA) un nombre d'étapes d'effacement partiel au maximum égal au nombre (N) de pages auxiliaires que contient le secteur courant.

10. Procédé selon l'une des revendications 1 à 9 comprenant, après effacement du secteur indisponible, une étape de rotation de secteurs comprenant les étapes consistant à :
- déclarer comme secteur courant (CUR) le secteur précédemment indisponible (UNA),
- déclarer comme secteur de sauvegarde (ERM) le secteur précédemment courant (CUR),
- déclarer comme secteur de transfert (CTM) le secteur précédemment de sauvegarde (ERM), et
- déclarer comme secteur indisponible (UNA) le secteur précédemment de transfert (CTM).

11. Procédé selon l'une des revendications 1 à 10, comprenant les étapes consistant à prévoir au moins un drapeau d'invalidation de page (IS, IOK) dans chaque page utile de la zone mémoire principale et de la zone mémoire auxiliaire, et invalider une page en portant le drapeau à une valeur logique de programmation.

12. Mémoire non volatile comportant des cellules mémoire devant être effacées avant d'être écrites, **caractérisé en ce qu'**elle comprend :
- une zone mémoire principale (MA) comprenant des pages cible,
- une zone mémoire auxiliaire (XA) comprenant des pages auxiliaires effacées utilisables pour écrire des données, des pages auxiliaires contenant des données rattachées à des pages cible à effacer ou en cours d'effacement, des pages auxiliaires contenant des données à transférer dans des pages cible effacées, et des pages auxiliaires à effacer ou en cours d'effacement,
**caractérisée en ce que** la zone mémoire auxiliaire comprend:
- un secteur courant (CUR) comprenant des pages auxiliaires effacées utilisables pour écrire des données,
- un secteur de sauvegarde (ERM) distinct du secteur courant, comprenant des pages auxiliaires contenant des données rattachées à des pages cible à effacer ou en cours d'effacement,
- un secteur de transfert (CTM) distinct du secteur courant et du secteur de sauvegarde, comprenant des pages auxiliaires contenant des données à transférer dans des pages cible effacées, et
- un secteur indisponible (UNA) distinct du secteur courant, du secteur de sauvegarde et du secteur de transfert, comprenant des pages auxiliaires à effacer ou en cours d'effacement.

13. Mémoire selon la revendication 12, comprenant une unité de contrôle de l'écriture de données configurée pour, en réponse à une commande d'écriture d'une donnée dans une page cible, effectuer les actions suivantes :
- appliquer (32) une étape d'effacement partiel aux pages auxiliaires du secteur indisponible (UNA) et à des pages cible (XA) rattachées à des pages du secteur de sauvegarde (CTM),
- transférer (34) des données d'une page auxiliaire du secteur de transfert (CTM) vers une page effacée de la zone mémoire principale (MA), si la page auxiliaire est valide, et invalider (36) la page auxiliaire,
- écrire (40) la donnée dans une page auxiliaire effacée du secteur courant, et invalider la page cible (42).

14. Mémoire selon la revendication 13, dans laquelle l'unité de contrôle est configurée pour, en réponse à une commande d'écriture d'une donnée dans une page cible :
- écrire (40) la donnée dans seconde page auxiliaire effacée, si une donnée précédente de même adresse de page cible a déjà été écrite dans une première page auxiliaire, et
- invalider (42) la première page auxiliaire.

15. Mémoire selon l'une des revendications 13 et 14, dans laquelle les pages auxiliaires comprennent un champ d'adresse (AF), et l'unité de contrôle est configurée pour écrire dans le champ d'adresse d'une page auxiliaire l'adresse de page cible d'une donnée écrite dans une page auxiliaire.

16. Mémoire selon l'une des revendications 12 à 15, dans laquelle l'unité de contrôle est configurée pour, en réponse à une commande d'écriture d'une donnée dans une page cible, écrire (22) directement la donnée dans la page cible ou dans une page auxiliaire valide contenant une donnée précédemment écrite ayant la même adresse de page cible, si des cellules mémoire devant recevoir la donnée sont effacées dans la page cible ou dans la page auxiliaire.

17. Mémoire selon l'une des revendications 12 à 16, dans laquelle l'unité de contrôle est configurée pour, avant d'écrire une donnée dans une page auxiliaire :
- lire (30) un ensemble initial de données dans une page source,
- insérer (30) la donnée à écrire dans l'ensemble initial de données, pour obtenir un ensemble de données mis à jour, puis
- écrire (40) l'ensemble de données mis à jour dans la page auxiliaire.

18. Mémoire selon l'une des revendications 12 à 17, dans laquelle l'unité de contrôle est configurée pour :
- tenir à jour une table de correspondance (VAM) entre des adresses de pages cible invalides et des adresses de pages auxiliaires valides, et
- lorsqu'une donnée doit être lue dans une page cible, lire la donnée dans une page auxiliaire valide si l'adresse de la page auxiliaire valide existe dans la table de correspondance, sinon lire la donnée dans la page cible.

19. Mémoire selon l'une des revendications 12 à 18, comprenant un pointeur (PT) de page auxiliaire pour désigner à la fois dans le secteur de transfert (CTM) une page auxiliaire dont le contenu doit être transféré dans une page cible et dans le secteur courant (CUR) une page effacée à utiliser pour écrire une donnée.

20. Mémoire selon l'une des revendications 12 à 19, dans laquelle l'unité de contrôle applique au secteur à effacer (UNA) un nombre d'étapes d'effacement partiel au maximum égal au nombre (N) de pages auxiliaires que contient le secteur courant.

21. Mémoire selon l'une des revendications 12 à 20, dans laquelle l'unité de contrôle est configurée pour, après avoir effacé le secteur indisponible :
- déclarer comme secteur courant (CUR) le secteur précédemment indisponible (UNA),
- déclarer comme secteur de sauvegarde (ERM) le secteur précédemment courant (CUR),
- déclarer comme secteur de transfert (CTM) le secteur précédemment de sauvegarde (ERM), et
- déclarer comme secteur indisponible (UNA) le secteur précédemment de transfert (CTM).

22. Mémoire selon l'une des revendications 12 à 21, dans laquelle chaque page utile de la zone mémoire principale et de la zone mémoire auxiliaire comprend au moins un drapeau d'invalidation de page (IS, IOK), et l'unité de contrôle est configurée pour invalider une page en portant le drapeau à une valeur logique de programmation.

23. Circuit intégré comprenant une mémoire selon l'une des revendications 12 à 22.

24. Carte à puce ou étiquette électronique comprenant un circuit intégré selon la revendication 23.

## Claims

1. Method for writing data in a non volatile memory comprising memory cells which must be erased before being written, comprising providing in the memory:
- a non volatile main memory area (MA) comprising target pages, and
- a non volatile auxiliary memory area (XA) comprising erased auxiliary pages usable to write data, auxiliary pages comprising data linked to target pages to be erased or being erased, auxiliary pages including data to be transferred to erased target pages, and auxiliary pages to be erased or being erased,
**characterised in that** it comprises providing, in the auxiliary memory area:
- a current sector (CUR) comprising erased auxiliary pages usable to write data,
- a save sector (ERM) different from the current sector, comprising auxiliary pages comprising data linked to target pages to be erased or being erased,
- a transfer sector (CTM) different from the current sector and the save sector, comprising auxiliary pages comprising data to be transferred to erased target pages, and
- an unavailable sector (UNA) different from the current sector, the save sector and the transfer sector, comprising auxiliary pages to be erased or being erased.

2. Method according to claim 1, comprising, in response to a command for writing a piece of data in a target page:
- applying (32) a step of partial erasure to the auxiliary pages of the unavailable sector (UNA) and to target pages (XA) linked to pages of the save sector (CTM),
- transferring (34) data from an auxiliary page of the transfer sector (CTM) to an erased page of the main memory area (MA), if the auxiliary page is valid, and invalidating (36) the auxiliary page, and
- writing (40) the piece of data in an erased auxiliary page of the current sector, and invalidating the target page (42).

3. Method according to claim 2, comprising, in response to a command for writing a piece of data in a target page:
- writing (40) the piece of data in a second erased auxiliary page, if a previous piece of data of same address of target page has already been written in a first auxiliary page, and
- invalidating (42) the first auxiliary page.

4. Method according to one of claims 2 and 3, comprising:
- providing an address field (AF) in the auxiliary pages, and
- when a piece of data is written in an auxiliary page, writing in the address field of the auxiliary page the address of target page of the piece of data.

5. Method according to one of claims 2 to 4, comprising, in response to a command for writing a piece of data in a target page, directly writing (22) the piece of data in the target page or in a valid auxiliary page comprising a piece of data previously written having the same address of target page, if some memory cells which must receive the piece of data are erased in the target page or in the auxiliary page.

6. Method according to one of claims 2 to 5, comprising:
- before writing a piece of data in an auxiliary page, reading (30) an initial set of data in a source page,
- inserting (30) the piece of data to be written into the initial set of data, to obtain an updated set of data, and
- writing (40) the updated set of data in the auxiliary page.

7. Method according to one of claims 1 to 6, comprising:
- updating a look-up table (VAM) between addresses of invalid target pages and addresses of valid auxiliary pages, and
- when a piece of data must be read in a target page, reading the piece of data in a valid auxiliary page if the address of the valid auxiliary page exists in the look-up table, if not, reading the piece of data in the target page.

8. Method according to one of claims 1 to 7, comprising using a pointer (PT) of auxiliary page to designate at the same time in the transfer sector (CTM) an auxiliary page which content must be transferred to a target page and in the current sector (CUR) an erased page to be used to write a piece of data.

9. Method according to one of claims 1 to 8, comprising applying to the sector to be erased (UNA) a number of steps of partial erasure equal at the maximum to the number (N) of auxiliary pages that the current sector contains.

10. Method according to one of claims 1 to 9, comprising, after erasing the unavailable sector, a step of rotating sectors comprising:
- declaring as current sector (CUR) the sector previously unavailable (UNA),
- declaring as save sector (ERM) the sector previously current (CUR),
- declaring as transfer sector (CTM) the sector previously save (ERM), and
- declaring as unavailable sector (UNA) the sector previously transfer (CTM).

11. Method according to one of claims 1 to 10, comprising providing at least one page invalidation flag (IS, IOK) in each useful page of the main memory area and the auxiliary memory area, and invalidating a page by bringing the flag to a programming logic value.

12. Non volatile memory comprising memory cells which must be erased before being written, **characterized in that** it comprises:
- a main memory area (MA) comprising target pages,
- an auxiliary memory area (XA) comprising erased auxiliary pages usable to write data, auxiliary pages comprising data linked to target pages to be erased or being erased, auxiliary pages including data to be transferred to erased target pages, and auxiliary pages to be erased or being erased,
**characterized in that** the auxiliary memory area comprises:
- a current sector (CUR) comprising erased auxiliary pages usable to write data,
- a save sector (ERM) different from the current sector, comprising auxiliary pages comprising data linked to target pages to be erased or being erased,
- a transfer sector (CTM) different from the current sector and the save sector, comprising auxiliary pages comprising data to be transferred to erased target pages, and
- an unavailable sector (UNA) different from the current sector, the save sector and the transfer sector, comprising auxiliary pages to be erased or being erased.

13. Memory according to claim 12, comprising a data writing control unit configured to, in response to a command for writing a piece of data in a target page, perform the following actions:
- applying (32) a step of partial erasure to the auxiliary pages of the unavailable sector (UNA) and to target pages (XA) linked to pages of the save sector (CTM),
- transferring (34) data from an auxiliary page of the transfer sector (CTM) to an erased page of the main memory area (MA), if the auxiliary page is valid, and invalidating (36) the auxiliary page,
- writing (40) the piece of data in an erased auxiliary page of the current sector, and invalidating the target page (42).

14. Memory according to claim 13, wherein the control unit is configured to, in response to a command for writing a piece of data in a target page:
- write (40) the piece of data in a second erased auxiliary page, if a previous piece of data of same address of target page has already been written in a first auxiliary page, and
- invalidate (42) the first auxiliary page.

15. Memory according to one of claims 13 and 14, wherein the auxiliary pages comprise an address field (AF), and the control unit is configured to write in the address field of an auxiliary page the address of target page of a piece of data written in an auxiliary page.

16. Memory according to one of claims 12 to 15, wherein the control unit is configured to, in response to a command for writing a piece of data in a target page, directly write (22) the piece of data in the target page or in a valid auxiliary page comprising a piece of data previously written having the same address of target page, if memory cells which must receive the piece of data are erased in the target page or in the auxiliary page.

17. Memory according to one of claims 12 to 16, wherein the control unit is configured to, before writing a piece of data in an auxiliary page:
- read (30) an initial set of data in a source page,
- insert (30) the piece of data to be written into the initial set of data, to obtain an updated set of data, and
- write (40) the updated set of data in the auxiliary page.

18. Memory according to one of claims 12 to 17, wherein the control unit is configured to:
- update a look-up table (VAM) between addresses of invalid target pages and addresses of valid auxiliary pages, and
- when a piece of data must be read in a target page, read the piece of data in a valid auxiliary page if the address of the valid auxiliary page exists in the look-up table, if not, read the piece of data in the target page.

19. Memory according to one of claims 12 to 18, comprising a pointer (PT) of auxiliary page to designate at the same time in the transfer sector (CTM) an auxiliary page which content must be transferred to a target page and in the current sector (CUR) an erased page to be used to write a piece of data.

20. Memory according to one of claims 12 to 19, wherein the control unit applies to the sector to be erased (UNA) a number of steps of partial erasure equal at the maximum to the number (N) of auxiliary pages that the current sector contains.

21. Memory according to one of claims 12 to 20, wherein the control unit is configured to, after erasing the unavailable sector:
- declare as current sector (CUR) the sector previously unavailable (UNA),
- declare as save sector (ERM) the sector previously current (CUR),
- declare as transfer sector (CTM) the sector previously save (ERM), and
- declare as unavailable sector (UNA) the sector previously transfer (CTM).

22. Memory according to one of claims 12 to 21, wherein each useful page of the main memory area and the auxiliary memory area comprises at least one page invalidation flag (IS, IOK), and the control unit is configured to invalidate a page by bringing the flag to a programming logic value.

23. Integrated circuit comprising a memory according to one of claims 12 to 22.

24. Chipcard or electronic tag comprising an integrated circuit according to claim 23.

## Patentansprüche

1. Verfahren zum Schreiben von Daten in einem nicht flüchtigen Speicher umfassend Speicherzellen, die zu löschen sind, bevor sie geschrieben werden, umfassend die Schritte, die darin bestehen, folgendes im Speicher vorzusehen:
- einen nicht flüchtigen Hauptspeicherbereich (MA) umfassend Zielseiten, und
- einen nicht flüchtigen Hilfsspeicherbereich (XA) umfassend gelöschte Hilfsseiten, die zum Schreiben von Daten verwendet werden können, Hilfsseiten, die Daten enthalten, die mit Zielseiten verknüpft sind, die zu löschen sind oder momentan gelöscht werden, Hilfsseiten, die Daten enthalten, die in gelöschte Zielseiten zu übertragen sind, und Hilfsseiten, die zu löschen sind oder momentan gelöscht werden,
**dadurch gekennzeichnet, dass** es die Schritte umfasst, die darin bestehen, folgendes im Hilfsspeicherbereich vorzusehen:
- einen laufenden Sektor (CUR) umfassend gelöschte Hilfsseiten, die zum Schreiben von Daten verwendet werden können,
- einen Speichersektor (ERM), der distinkt vom laufenden Sektor ist, umfassend Hilfsseiten, die Daten enthalten, die mit Zielseiten verknüpft sind, die zu löschen sind oder momentan gelöscht werden,
- einen Übertragungssektor (CTM), der distinkt vom laufenden Sektor und vom Speichersektor ist, umfassend Hilfsseiten, die Daten enthalten, die in gelöschte Zielseiten zu übertragen sind, und
- einen unverfügbaren Sektor (UNA), der distinkt vom laufenden Sektor, vom Speichersektor und vom Übertragungssektor ist, umfassend Hilfsseiten, die zu löschen sind oder momentan gelöscht werden.

2. Verfahren nach Anspruch 1, umfassend als Antwort auf einen Befehl zum Schreiben eines Datums in einer Zielseite, die Schritte, die darin bestehen,:
- einen Schritt des partiellen Löschens an die Hilfsseiten des unverfügbaren Sektors (UNA) und an Zielseiten (XA), die mit Seiten des Speichersektors (CTM) verknüpft sind, anzuwenden (32),
- Daten einer Hilfsseite des Übertragungssektors (CTM) zu einer gelöschten Seite des Hauptspeicherbereiches (MA) zu übertragen (34), wenn die Hilfsseite gültig ist, und die Hilfsseite ungültig zu machen (36), und
- das Datum in einer gelöschten Hilfsseite des laufenden Sektors zu schreiben (40), und die Zielseite (42) ungültig zu machen.

3. Verfahren nach Anspruch 2, umfassend als Antwort auf einen Befehl zum Schreiben eines Datums in einer Zielseite, die Schritte, die darin bestehen,:
- das Datum in einer zweiten gelöschten Hilfsseite zu schreiben (40), wenn ein vorhergehendes Datum derselben Zielseitenadresse bereits in einer ersten Hilfsseite geschrieben wurde, und
- die erste Hilfsseite ungültig zu machen (42).

4. Verfahren nach einem der Ansprüche 2 und 3, umfassend die Schritte, die darin bestehen,:
- ein Adressfeld (AF) in den Hilfsseiten vorzusehen, und
- wenn ein Datum in einer Hilfsseite geschrieben ist, im Adressfeld der Hilfsseite die Zielseitenadresse des Datums zu schreiben.

5. Verfahren nach einem der Ansprüche 2 bis 4, umfassend als Antwort auf einen Befehl zum Schreiben eines Datums in einer Zielseite, den Schritt (22), der darin besteht, das Datum direkt in der Zielseite oder in einer gültigen Hilfsseite zu schreiben, die ein vorher geschriebenes Datum mit der selben Zielseitenadresse enthält, wenn Speicherzellen, die das Datum empfangen sollen, in der Zielseite oder in der Hilfsseite gelöscht sind.

6. Verfahren nach einem der Ansprüche 2 bis 5, umfassend die Schritte, die darin bestehen,:
- bevor ein Datum in einer Hilfsseite geschrieben wird, einen initialen Datensatz in einer Quellseite zu lesen (30),
- das zu schreibende Datum in den initialen Datensatz einzufügen (30), um einen aktualisierten Datensatz zu erhalten, dann
- den aktualisierten Datensatz in der Hilfsseite zu schreiben (40).

7. Verfahren nach einem der Ansprüche 1 bis 6, umfassend die Schritte, die darin bestehen,:
- eine Korrespondenztabelle (VAM) zwischen Adressen ungültiger Zielseiten und Adressen gültiger Hilfsseiten auf dem aktuellen Stand zu halten, und
- wenn ein Datum in einer Zielseite gelesen werden soll, das Datum in einer gültigen Hilfsseite zu lesen, wenn die Adresse der gültigen Hilfsseite in der Korrespondenztabelle existiert, ansonsten das Datum in der Zielseite zu lesen.

8. Verfahren nach einem der Ansprüche 1 bis 7, umfassend einen Schritt, der darin besteht, einen Hilfsseiten-Zeiger (PT) zu verwenden, um gleichzeitig im Übertragungssektor (CTM) eine Hilfsseite, deren Inhalt in eine Zielseite übertragen werden soll, und im laufenden Sektor (CUR) eine gelöschte Seite, die zum Schreiben eines Datums verwendet werden soll, zu bestimmen.

9. Verfahren nach einem der Ansprüche 1 bis 8, umfassend den Schritt, der darin besteht, an den zu löschenden Sektor (UNA) eine Anzahl Schritte des partiellen Löschens anzuwenden, die höchstens der Anzahl (N) von Hilfsseiten entspricht, die der laufende Sektor enthält.

10. Verfahren nach einem der Ansprüche 1 bis 9, nach Löschen des unverfügbaren Sektors einen Schritt der Sektorrotation umfassend, der die Schritte umfasst, die darin bestehen,:
- den vorher unverfügbaren Sektor (UNA) zum laufenden Sektor (CUR) zu erklären,
- den vorher laufenden Sektor (CUR) zum Speichersektor (ERM) zu erklären,
- den vorherigen Speichersektor (ERM) zum Übertragungssektor (CTM) zu erklären, und
- den vorherigen Übertragungssektor (CTM) zum unverfügbaren Sektor (UNA) zu erklären.

11. Verfahren nach einem der Ansprüche 1 bis 10, umfassend die Schritte, die darin bestehen, zumindest ein Seiten-Ungültigkeitskennzeichen (IS, IOK) in jeder nützlichen Seite des Hauptspeicherbereiches und des Hilfsspeicherbereiches vorzusehen, und eine Seite ungültig zu machen, indem das Kennzeichen auf einen logischen Programmierwert gesetzt wird.

12. Nicht flüchtiger Speicher umfassend Speicherzellen, die zu löschen sind, bevor sie geschrieben werden, **dadurch gekennzeichnet, dass** er folgendes umfasst:
- einen Hauptspeicherbereich (MA) mit Zielseiten,
- einen Hilfsspeicherbereich (XA) mit gelöschten Hilfsseiten, die zum Schreiben von Daten verwendet werden können, Hilfsseiten, die Daten enthalten, die mit Zielseiten verknüpft sind, die zu löschen sind oder momentan gelöscht werden, Hilfsseiten, die Daten enthalten, die in gelöschte Zielseiten zu übertragen sind, und Hilfsseiten, die zu löschen sind oder momentan gelöscht werden,
**dadurch gekennzeichnet, dass** der Hilfsspeicherbereich folgendes umfasst:
- einen laufenden Sektor (CUR) umfassend gelöschte Hilfsseiten, die zum Schreiben von Daten verwendet werden können,
- einen Speichersektor (ERM), der distinkt vom laufenden Sektor ist, umfassend Hilfsseiten, die Daten enthalten, die mit Zielseiten verknüpft sind, die zu löschen sind oder momentan gelöscht werden,
- einen Übertragungssektor (CTM), der distinkt vom laufenden Sektor und vom Speichersektor ist, umfassend Hilfsseiten, die Daten enthalten, die in gelöschte Zielseiten zu übertragen sind, und
- einen unverfügbaren Sektor (UNA), der distinkt vom laufenden Sektor, vom Speichersektor und vom Übertragungssektor ist, umfassend Hilfsseiten, die zu löschen sind oder momentan gelöscht werden.

13. Speicher nach Anspruch 12, umfassend eine Einheit zum Steuern des Schreibens von Daten, die konfiguriert ist, um als Antwort auf einen Befehl zum Schreiben eines Datums in einer Zielseite folgende Aktionen auszuführen:
- einen Schritt des partiellen Löschens an die Hilfsseiten des unverfügbaren Sektors (UNA) und an Zielseiten (XA), die mit Seiten des Speichersektors (CTM) verknüpft sind, anwenden (32),
- Daten einer Hilfsseite des Übertragungssektors (CTM) zu einer gelöschten Seite des Hauptspeicherbereiches (MA) übertragen (34), wenn die Hilfsseite gültig ist, und die Hilfsseite ungültig machen (36),
- das Datum in einer gelöschten Hilfsseite des laufenden Sektors schreiben (40), und die Zielseite (42) ungültig machen.

14. Speicher nach Anspruch 13, in dem die Steuereinheit konfiguriert ist, um als Antwort auf einen Befehl zum Schreiben eines Datums in einer Zielseite:
- das Datum in einer zweiten gelöschten Hilfsseite zu schreiben (40), wenn ein vorhergehendes Datum derselben Zielseitenadresse bereits in einer ersten Hilfsseite geschrieben wurde, und
- die erste Hilfsseite ungültig zu machen (42).

15. Speicher nach einem der Ansprüche 13 und 14, in dem die Hilfsseiten ein Adressfeld (AF) umfassen, und die Steuereinheit konfiguriert ist, um im Adressfeld einer Hilfsseite die Zielseitenadresse eines Datums, das in einer Hilfsseite geschrieben ist, zu schreiben.

16. Speicher nach einem der Ansprüche 12 bis 15, in dem die Steuereinheit konfiguriert ist, um als Antwort auf einen Befehl zum Schreiben eines Datums in einer Zielseite, das Datum direkt in der Zielseite oder in einer gültigen Hilfsseite, die ein vorher geschriebenes Datum mit der selben Zielseitenadresse enthält, zu schreiben (22), wenn Speicherzellen, die das Datum empfangen sollen, in der Zielseite oder in der Hilfsseite gelöscht sind.

17. Speicher nach einem der Ansprüche 12 bis 16, in dem die Steuereinheit konfiguriert ist, um vor dem Schreiben eines Datums in einer Hilfsseite:
- einen initialen Datensatz in einer Quellseite zu lesen (30),
- das zu schreibende Datum in den initialen Datensatz einzufügen (30), um einen aktualisierten Datensatz zu erhalten, dann
- den aktualisierten Datensatz in der Hilfsseite zu schreiben (40).

18. Speicher nach einem der Ansprüche 12 bis 17, in dem die Steuereinheit konfiguriert ist, um:
- eine Korrespondenztabelle (VAM) zwischen Adressen ungültiger Zielseiten und Adressen gültiger Hilfsseiten auf dem aktuellen Stand zu halten, und
- wenn ein Datum in einer Zielseite gelesen werden soll, das Datum in einer gültigen Hilfsseite zu lesen, wenn die Adresse der gültigen Hilfsseite in der Korrespondenztabelle existiert, ansonsten das Datum in der Zielseite zu lesen.

19. Speicher nach einem der Ansprüche 12 bis 18, umfassend einen Hilfsseiten-Zeiger (PT), um gleichzeitig im Übertragungssektor (CTM) eine Hilfsseite, deren Inhalt in eine Zielseite übertragen werden soll, und im laufenden Sektor (CUR) eine gelöschte Seite, die verwendet werden soll, um ein Datum zu schreiben, zu bestimmen.

20. Speicher nach einem der Ansprüche 12 bis 19, in dem die Steuereinheit an den zu löschenden Sektor (UNA) eine Anzahl Schritte des partiellen Löschens anwendet, die höchstens der Anzahl (N) von Hilfsseiten entspricht, die der laufende Sektor enthält.

21. Speicher nach einem der Ansprüche 12 bis 20, in dem die Steuereinheit konfiguriert ist, um nach Löschen des unverfügbaren Sektors:
- den vorher unverfügbaren Sektor (UNA) zum laufenden Sektor (CUR) zu erklären,
- den vorher laufenden Sektor (CUR) zum Speichersektor (ERM) zu erklären,
- den vorherigen Speichersektor (ERM) zum Übertragungssektor (CTM) zu erklären, und
- den vorherigen Übertragungssektor (CTM) zum unverfügbaren Sektor (UNA) zu erklären.

22. Speicher nach einem der Ansprüche 12 bis 21, in dem jede nützliche Seite des Hauptspeicherbereiches und des Hilfsspeicherbereiches zumindest ein Seiten-Ungültigkeitskennzeichen (IS, IOK) umfasst, und die Steuereinheit konfiguriert ist, um eine Seite ungültig zu machen, indem das Kennzeichen auf einen logischen Programmierwert gesetzt wird.

23. Integrierte Schaltung, umfassend einen Speicher nach einem der Ansprüche 12 bis 22.

24. Chipkarte oder elektronisches Etikett, umfassend eine integrierte Schaltung nach Anspruch 23.
